# FASCICULE DE BREVET EUROPEEN

(11) **EP 2 681 739 B1**
(45) Date de publication et mention de la délivrance du brevet: **08.02.2017**
(21) Numéro de dépôt: 12752402.3
(22) Date de dépôt: 02.03.2012
(51) Int. Cl.: G11C 11/16

(54) **DISPOSITIF MAGNETIQUE ET PROCEDE D'ECRITURE ET DE LECTURE D'UNE INFORMATION STOCKEE DANS UN TEL DISPOSITIF MAGNETIQUE**
MAGNETISCHE VORRICHTUNG UND VERFAHREN ZUM BESCHREIBEN UND LESEN EINES IN EINER DERARTIGEN MAGNETISCHEN VORRICHTUNG GESPEICHERTEN INFORMATIONSELEMENTS
MAGNETIC DEVICE AND METHOD FOR WRITING AND READING AN ITEM OF INFORMATION STORED IN SUCH A MAGNETIC DEVICE

(30) Priorité: 02.03.2011 FR 1151681
(43) Date de publication de la demande: 08.01.2014
(73) Titulaire: Commissariat à l'Énergie Atomique et aux Énergies Alternatives, 75015 Paris (FR)
(72) Inventeur: DIENY, Bernard, F-38250 Lans en Vercors (FR)
(74) Mandataire: Lebkiri, Alexandre
(86) Numéro de dépôt international: PCT/FR2012/050444
(87) Numéro de publication internationale: WO 2012/117212

(56) Documents cités:
- FR-A1- 2 879 349
- US-A1- 2010 135 072

## Description

La présente invention concerne un dispositif magnétique de type mémoire MRAM (Magnetic Random Access Memory) qui comporte au moins un point mémoire.

Les mémoires magnétiques MRAM ont connu un regain d'intérêt avec la mise au point de jonctions tunnels magnétiques présentant une forte magnétorésistance à température ambiante. Les mémoires MRAM comportent généralement plusieurs points mémoires. Ces points mémoires sont généralement des dispositifs magnétiques qui comportent :
- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- un espaceur réalisé dans un matériau isolant ou semi-conducteur qui sépare la couche de référence et la couche de stockage.

Le document FR2817999 décrit par exemple un tel dispositif magnétique. Chaque point mémoire présente deux modes de fonctionnement : un mode « lecture » et un mode « écriture ». Lors du mode écriture, un courant d'électrons est envoyé à travers les couches ou un champ magnétique est appliqué sur la couche de stockage du point mémoire, de façon à provoquer le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage.

Lors du mode lecture, un courant d'électrons est injecté à travers le point mémoire de façon à lire sa résistance. Lorsque les directions d'aimantation de la couche de référence et de la couche de stockage sont parallèles, la résistance du point mémoire est faible, tandis que lorsque les directions d'aimantation des couches de référence et de stockage sont antiparallèles, la résistance du point mémoire est élevée. Par comparaison avec une résistance de référence, la valeur stockée dans la couche de stockage (« 0 » ou « 1 ») peut être déterminée.

Toutefois, les valeurs des résistances lorsque les couches de référence et de stockage sont parallèles ou antiparallèles peuvent varier d'un point mémoire à l'autre. Par conséquent, lorsque l'on compare la résistance d'un point mémoire à une valeur de référence standard, le résultat de la comparaison n'est parfois pas représentatif de l'état réel du point mémoire du fait des différences entre ce point mémoire et le point mémoire qui a permis d'établir la valeur de référence standard.

Pour remédier à ce problème, des dispositifs magnétiques ont été mis au point qui comportent une couche de référence dont la direction d'aimantation est variable.

Ainsi, le document US2010/0135072 décrit un dispositif magnétique qui comporte des points mémoires, chaque point mémoire comportant :
- une couche de stockage ;
- un espaceur ;
- une couche de référence dont la direction d'aimantation est variable ;
- un conducteur qui, lorsqu'il est traversé par un courant d'électrons, génère un champ magnétique, la direction du courant d'électrons pouvant être choisie de façon à contrôler la direction du champ magnétique généré ;
- des moyens d'injection d'un courant d'électrons à travers le point mémoire.

Ce dispositif est particulièrement avantageux car il permet de lire l'information stockée dans la couche de stockage sans avoir à utiliser de valeur de résistance de référence. En effet, ce dispositif magnétique permet de réaliser une lecture différentielle de l'information contenue dans la couche de stockage à l'aide de la couche de référence.

Pour cela, on calcule la résistance du point mémoire quand la direction d'aimantation de la couche de référence est dans un sens, puis on calcule la résistance de ce même point mémoire quand la direction d'aimantation de la couche de référence est dans l'autre sens. On compare ensuite les valeurs de ces deux résistances de façon à en déduire la direction de l'aimantation de la couche de stockage.

Pour cela, on oriente, avec un premier pulse de champ magnétique, la direction d'aimantation de la couche de référence dans un sens prédéterminé. On mesure alors la résistance du point mémoire. On applique ensuite un deuxième pulse de champ magnétique de façon à orienter la direction d'aimantation de la couche de référence dans le sens opposé au premier sens prédéterminé. On mesure alors à nouveau la résistance du point mémoire. Après chaque pulse de courant, on connaît la direction d'aimantation de la couche de référence, puisqu'on connaît la direction des pulses de champs magnétiques appliqués. Par conséquent, en comparant la résistance du point mémoire après le premier pulse de courant et après le deuxième pulse de courant, on en déduit la direction d'aimantation de la couche de stockage. Ce mode de lecture de l'information contenue dans la couche de stockage est particulièrement avantageux car il permet une lecture plus précise de l'information contenue dans la couche de stockage et d'avoir des résultats moins sensibles aux fluctuations de résistance d'un point mémoire à l'autre.

La meilleure précision de lecture est obtenue puisqu'on n'utilise plus de valeur de référence standard, mais on place un même point mémoire dans deux états et on compare ces deux états entre eux, ce qui permet d'avoir des résultats moins sensibles aux fluctuations de résistance d'un point mémoire à l'autre. Ceci permet de tolérer davantage de dispersion dans les résistances et amplitudes de magnétorésistance.

Toutefois, le dispositif décrit dans ce document nécessite l'utilisation de courants relativement importants pour générer un champ magnétique permettant de faire commuter la direction d'aimantation de la couche de référence.

FR 2879349 décrit un dispositif électronique de spin à commande par déplacement de parois induit par un courant de porteurs polarisés en spin.

L'invention vise à remédier, au moins partiellement, aux inconvénients de l'état de la technique en proposant un dispositif magnétique qui permet l'utilisation de courants très faibles pour faire commuter la direction d'aimantation de la couche de référence.

Pour ce faire, l'invention propose un dispositif magnétique comportant :
- au moins un point mémoire comportant :
   ∘ une première couche magnétique dite « couche de référence », la couche de référence présentant une direction d'aimantation variable ;
   ∘ une deuxième couche magnétique dite « couche de stockage », la couche de stockage présentant une direction d'aimantation variable ;
   ∘ un espaceur qui sépare la couche de référence et la couche de stockage, la couche de référence et la couche de stockage étant découplées magnétiquement à travers l'espaceur ;
   ∘ des moyens aptes à faire passer un courant d'électrons transversal de lecture à travers le point mémoire ;
le dispositif magnétique comportant en outre :
- une troisième couche magnétique dite « ligne de référence » en contact avec la couche de référence, la ligne de référence présentant une première extrémité et une deuxième extrémité ;
- des moyens d'injection aptes à injecter un courant d'électrons polarisé en spin à chaque extrémité de la ligne de référence de façon à retourner l'aimantation de la ligne de référence par propagation d'une paroi magnétique à travers la ligne de référence, la paroi magnétique se propageant depuis une zone proche d'une des extrémités de la ligne de référence jusqu'à une zone proche de l'autre extrémité de la ligne de référence.

Le dispositif magnétique est particulièrement avantageux en ce que la ligne de référence permet de faire commuter la direction d'aimantation de la couche de référence avec des courants très faibles, de l'ordre de une ou quelques dizaines de microampères dans l'état actuel de la technique. En effet, la couche de référence est en contact avec la ligne de référence de sorte que la couche de référence et la ligne de référence sont couplées magnétiquement. Ainsi, lorsque la direction d'aimantation de la ligne de référence commute, la direction d'aimantation de la couche de référence commute également.

Pour faire commuter la direction d'aimantation de la ligne de référence, on fait circuler un courant à travers la ligne de référence dans un sens particulier. Le fait de faire circuler un courant d'électrons polarisé en spin dans la ligne de référence permet de nucléer à chaque extrémité de la ligne de référence un domaine magnétique qui présente la direction d'aimantation voulue.

Ce procédé dit de de nucléation à chaque extrémité de la ligne de référence est réalisé en injectant à une extrémité de la ligne de référence des électrons dont la polarisation en spin est opposée à l'aimantation de la ligne de référence et en retirant de l'autre extrémité de la ligne de référence des électrons dont la polarisation en spin est parallèle à l'aimantation de la ligne de référence. Sous l'effet du courant d'électrons circulant dans la ligne de référence, le domaine magnétique en amont du courant d'électrons s'étend à l'ensemble de la ligne de référence lorsque le courant d'électron polarisé traverse la ligne de référence de part en part. En effet, sous l'effet de la pression exercée par le courant d'électrons polarisé en spin, la paroi du domaine magnétique se propage d'une extrémité à l'autre de la ligne de référence dans le sens d'écoulement des électrons à cause du phénomène de transfert de spin. Ce mode de retournement de l'aimantation d'une ligne magnétique impliquant la propagation d'une paroi magnétique le long de cette ligne sous l'effet d'un courant d'électrons circulant dans la ligne est décrit par exemple dans l'article de P.Braganca et al, IEEE Trans.on Nanotechnology, 8 (2009), 190.

Selon l'invention, de manière particulièrement avantageuse, il n'y a pas de paroi préexistante dans le dispositif avant de chercher à écrire une information. La ligne de référence peut être complètement monodomaine au repos (donc sans paroi). Ce sont les moyens d'injection d'un courant polarisé en spin que l'on dispose aux extrémités qui vont nucléer le domaine inverse et donc permettre l'apparition de la paroi que l'on fait ensuite se propager le long de toute la ligne. L'existence de la paroi est donc un phénomène transitoire existant pendant l'événement d'écriture. A chaque fois, la paroi s'évacue en bout de ligne et disparait.

Le dispositif magnétique peut également présenter une ou plusieurs des caractéristiques ci-après, prises individuellement ou selon toutes les combinaisons techniquement possibles.

Selon un mode de réalisation préférentiel, le dispositif magnétique comporte au moins deux points mémoires en contact avec la ligne de référence. La ligne de référence permet alors de faire commuter simultanément les directions d'aimantation de tous les points mémoires en contact avec elle.

Selon un mode de réalisation préférentiel, les moyens d'injection comportent :
- une alimentation apte à générer un courant d'électrons ;
- des premiers moyens de circulation d'un courant d'électrons polarisé en spin disposés au contact de la première extrémité de la ligne de référence, les premiers moyens de circulation d'un courant d'électrons polarisés en spin étant aptes à polariser en spin le courant d'électrons issu de l'alimentation dans une première direction ;
- des deuxièmes moyens de circulation d'un courant d'électrons polarisé en spin disposés au contact de la deuxième extrémité de la ligne de référence, les deuxièmes moyens de circulation d'un courant d'électrons polarisés en spin étant apte à polariser en spin le courant d'électrons issu de l'alimentation dans une deuxième direction, la deuxième direction étant opposée à la première direction ;

Ainsi, les moyens d'injection permettent d'injecter à chaque extrémité de la ligne de référence un courant d'électrons polarisé en spin, le courant d'électrons qui est injecté dans la première extrémité de la ligne de référence présentant un spin opposé au courant d'électrons qui est injecté dans la deuxième extrémité de la ligne de référence.

Avantageusement, les premiers moyens de circulation d'un courant d'électrons polarisés en spin comportent une première couche de polarisation présentant une direction d'aimantation fixe.

Ainsi, lorsqu'un courant d'électrons circule à travers les premiers moyens de circulation d'un courant d'électrons polarisé en spin et à travers la ligne de référence, le courant d'électrons généré par l'alimentation devient polarisé en spin en traversant la première couche de polarisation. Le sens du courant envoyé dans la ligne de référence est choisi de sorte que le couple de transfert de spin exercé par ce courant injecté tende à faire commuter l'aimantation de la ligne de référence dans le sens opposé de son sens initial. Ainsi, si l'aimantation de la première couche de polarisation est dirigée dans le sens opposé du sens de l'aimantation initiale de la ligne de référence alors les électrons sont injectés de la première couche de polarisation vers la ligne de référence donc le courant circule de la ligne de référence vers la première couche de polarisation. Si par contre l'aimantation de la première couche de polarisation est initialement parallèle à celle de la ligne de référence alors le courant circulera de la première couche de polarisation vers la ligne de référence.

Avantageusement, les premiers moyens de circulation d'un courant d'électrons polarisés en spin comportent une première couche antiferromagnétique en contact avec la première couche de polarisation. Cette première couche antiferromagnétique permet de fixer la direction d'aimantation de la première couche de polarisation.

Avantageusement, les premiers moyens de circulation d'un courant d'électrons polarisé en spin comportent une première couche non-magnétique disposée entre la première couche de polarisation et la première extrémité de la ligne de référence.

Cette première couche non-magnétique permet le passage du courant des premiers moyens de circulation d'un courant d'électrons polarisé en spin vers la ligne de référence. Cette première couche non-magnétique peut être en métal ou être une barrière tunnel. Elle permet en outre de découpler magnétiquement, en l'absence de courant d'électrons, l'aimantation de la première couche de polarisation de celle de l'aimantation de la ligne de référence.

Avantageusement, les premiers moyens de circulation d'un courant d'électrons polarisé en spin comportent une deuxième couche de métal électriquement conducteur disposée entre l'alimentation et la première couche antiferromagnétique. Cette deuxième couche de métal électriquement conducteur permet le passage du courant à travers les premiers moyens de circulation d'un courant d'électrons polarisé en spin.

Selon un mode de réalisation, les deuxièmes moyens de circulation d'un courant d'électrons polarisé en spin comportent une deuxième couche de polarisation présentant une direction d'aimantation fixe, la direction d'aimantation de la deuxième couche de polarisation étant opposée à la direction d'aimantation de la première couche de polarisation. Cette deuxième couche de polarisation permet d'injecter dans la deuxième extrémité de la ligne de référence un courant d'électrons de polarisation opposée à la polarisation du courant d'électrons qui est injecté dans la première extrémité de la ligne de référence.

Selon un mode de réalisation, les deuxièmes moyens de circulation d'un courant d'électrons polarisé en spin comportent une troisième couche antiferromagnétique en contact avec la deuxième couche de polarisation, la troisième couche antiferromagnétique étant apte à piéger la direction d'aimantation de la deuxième couche de polarisation.

Cette troisième couche antiferromagnétique permet à la deuxième couche de polarisation d'avoir une direction d'aimantation de direction opposée à celle de la première couche de polarisation.

Pour cela, la troisième couche antiferromagnétique présente de préférence une température de blocage différente de celle de la première couche antiferromagnétique. Comme bien connu de l'homme de l'art, par température de blocage, on entend la température jusqu'à laquelle l'interaction magnétique entre la couche antiferromagnétique et la couche ferromagnétique adjacente arrive à induire un piégeage de l'aimantation de la couche ferromagnétique adjacente, lequel piégeage se manifeste par un décalage selon l'axe du champ appliqué du cycle d'hystérésis de l'aimantation de la couche ferromagnétique adjacente. Au dessus de la température de blocage, ce décalage de cycle s'annule. Ces notions sont décrites par exemple dans l'article de Nogues et al, Journ.Magn.Magn.Materials 192 (1999) 203.

Le principe pour aligner les aimantations des deux couches de polarisation en direction opposée est alors le suivant. Supposons sans nuire à la généralité que la température de blocage de la troisième couche antiferromagnétique soit supérieure à celle de la première couche antiferromagnétique. On chauffe alors le dispositif à une température légèrement supérieure à la température de blocage de la troisième couche antiferromagnétique en appliquant un champ magnétique suffisamment fort pour polariser l'aimantation de la deuxième couche de polarisation dans sa direction. On refroidit alors le dispositif dans ce champ jusqu'à la température de blocage de la première couche antiferromagnétique. On renverse alors le champ magnétique dans la direction opposée, le champ étant suffisamment fort pour polariser l'aimantation de la première couche de polarisation dans la direction du champ magnétique. On refroidit alors le dispositif jusqu'à la température ambiante dans ce champ magnétique. A l'issue de cette opération les aimantations des deux couches de polarisation et se trouvent piégées dans des directions opposées.

Selon un autre mode de réalisation, les deuxièmes moyens de circulation d'un courant d'électrons polarisé en spin comportent :
- une troisième couche antiferromagnétique en contact avec une couche ferromagnétique dite d'orientation. Contrairement au mode de réalisation décrit juste précédemment, cette troisième couche antiferromagnétique n'a pas besoin d'avoir une température de blocage différente de celle de la première couche antiferromagnétique. Avantageusement, cette troisième couche antiferromagnétique peut être constituée du même matériau que la première couche antiferromagnétique.
- une couche ferromagnétique dite d'orientation présentant une direction d'aimantation fixe, la direction d'aimantation de la couche ferromagnétique d'orientation étant opposée à la direction d'aimantation de la première couche de polarisation ;
- une première couche de couplage antiferromagnétique insérée entre la deuxième couche ferromagnétique de polarisation et la couche ferromagnétique d'orientation.

Le but de l'introduction de la couche ferromagnétique d'orientation et de la troisième couche antiferromagnétique est de permettre l'orientation des aimantations de la première et seconde couches de polarisation dans des directions opposées. En effet lors d'un recuit au-dessus de la température de blocage des première et troisième couches antiferromagnétiques dans un champ modéré, il est possible d'orienter l'aimantation de la première couche de polarisation parallèlement au champ ainsi que celle de la couche ferromagnétique d'orientation qui a un moment supérieur à celui de la deuxième couche de polarisation. Par champ modéré, on entend un champ suffisamment fort pour orienter l'aimantation de la première couche de polarisation et celle de la couche ferromagnétique d'orientation dans la direction du champ mais pas trop fort pour ne pas vaincre le couplage antiferromagnétique entre la couche ferromagnétique d'orientation et la deuxième couche de polarisation c'est-à-dire que le champ magnétique appliqué doit être inférieur au champ dit de « spin-flop ». Le champ de spin-flop est le champ auquel deux couches magnétiques couplées antiferromagnétiquement soumises à un champ magnétique transitent d'une situation à champ faible, c'est-à-dire en dessous du champ de spin-flop, où leurs aimantations sont orientées antiparallèlement vers une situation à champ fort, c'est-à-dire au dessus du champ de spin-flop, où leurs aimantations forment entre elles un angle inférieur à 180° degrés et se fermant progressivement jusqu'à devenir parallèles lorsque le champ excède le champ de saturation. Comme le moment magnétique de la couche d'orientation a été choisi supérieur à celui de la deuxième couche de polarisation, l'aimantation de la couche d'orientation va s'orienter parallèlement à la direction du champ modéré appliqué et celle de la deuxième couche de polarisation va s'orienter antiparallèlement à la direction du champ modéré appliqué. Ainsi à l'issue du refroidissement du dispositif magnétique sous champ magnétique modéré depuis une température supérieure à la température de blocage des première et troisième couches antiferromagnétiques jusqu'à la température ambiante, l'aimantation de la première couche de polarisation se trouvera piégée parallèlement à la direction du champ modéré tandis que l'aimantation de la deuxième couche de polarisation se trouvera piégée en direction opposée à celle du champ modéré appliqué pendant le refroidissement.

Avantageusement, les deuxièmes moyens de circulation d'un courant d'électrons polarisé en spin comportent une troisième couche non-magnétique disposée entre la deuxième couche de polarisation et la deuxième extrémité de la ligne de référence.

La troisième couche non-magnétique peut être en métal ou être une barrière tunnel.

Cette troisième couche non-magnétique permet le passage du courant des deuxièmes moyens de circulation d'un courant d'électrons polarisé en spin vers la ligne de référence. Cette troisième couche non-magnétique permet en outre de découpler magnétiquement, en l'absence de courant d'électrons, l'aimantation de la deuxième couche de polarisation de celle de l'aimantation de la ligne de référence.

Avantageusement, les deuxièmes moyens de circulation d'un courant d'électrons polarisé en spin comportent une quatrième couche de métal électriquement conducteur. Cette quatrième couche de métal électriquement conducteur permet le passage du courant à travers les deuxièmes moyens de circulation d'un courant d'électrons polarisé en spin.

Selon différents modes de réalisation :
- la couche de stockage est formée d'une monocouche magnétique ou bien
- la couche de stockage est formée d'un empilement tricouche antiferromagnétique synthétique comportant deux couches magnétiques séparées par une couche conductrice non magnétique. Les deux couches magnétiques sont couplées antiparallèlement à travers la couche conductrice non magnétique. Ce mode de réalisation est avantageux car il permet d'avoir une aimantation plus uniforme et il permet d'avoir une plus grande stabilité thermique puisque le volume de la couche de stockage est plus important que dans le cas où la couche de stockage est une monocouche.

Selon un mode de réalisation, le dispositif magnétique comporte en outre une deuxième couche antiferromagnétique au contact de la couche de stockage. La présence de la deuxième couche antiferromagnétique permet d'augmenter la stabilité thermique de l'information stockée dans la couche de stockage. En effet, en mode lecture, la deuxième couche antiferromagnétique permet de figer la direction d'aimantation de la couche de stockage afin que l'information stockée dans la couche de stockage ne varie pas pendant la lecture. En mode écriture par contre, lorsqu'un courant d'électrons transversal est envoyé à travers le point mémoire, ce courant chauffe la deuxième couche antiferromagnétique de sorte que la deuxième couche antiferromagnétique atteint une température supérieure à sa température de blocage. La deuxième couche antiferromagnétique libère alors la direction d'aimantation de la couche de stockage. Simultanément, ce courant d'électrons transversal permet de modifier la direction d'aimantation de la couche de stockage en fonction de la direction d'aimantation de la couche de référence par transfert de spin. Une fois que la direction d'aimantation de la couche de stockage a commuté, le courant est arrêté, ce qui fait que le chauffage de la deuxième couche antiferromagnétique s'arrête. La deuxième couche antiferromagnétique piège alors à nouveau la direction d'aimantation de la couche de stockage.

Selon différents modes de réalisation :
- chaque couche magnétique du dispositif magnétique présente une direction d'aimantation qui est comprise dans le plan de ladite couche magnétique ; ce mode de réalisation est avantageux car il est simple à réaliser ;
- chaque couche magnétique du dispositif magnétique présente une direction d'aimantation qui est perpendiculaire au plan dans lequel se trouve ladite couche magnétique ; ce dernier mode de réalisation est avantageux car le dispositif magnétique ainsi réalisé présente une stabilité thermique améliorée.

Un autre aspect de l'invention concerne également un procédé d'écriture dit « monopolaire » d'une information dans la couche de stockage d'un des points mémoires d'un dispositif magnétique tel que décrit précédemment, le procédé comportant les étapes suivantes :
- une étape d'envoi à travers la ligne de référence d'un courant d'électrons polarisé en spin de façon à contrôler la direction d'aimantation de la ligne de référence ;
- une étape d'envoi au travers du point mémoire d'un courant d'électrons transversal de façon à modifier, par transfert de spin, la direction d'aimantation de la couche de stockage en fonction de la direction d'aimantation de la couche de référence.

Le courant d'électrons transversal présente de préférence une polarité constante quelque soit l'information à écrire dans la couche de stockage.

Selon ce procédé d'écriture, pour faire commuter la direction d'aimantation de la couche de stockage, on fait donc d'abord commuter la direction d'aimantation de la couche de référence, en faisant commuter la direction d'aimantation de la ligne de référence grâce à l'envoi d'un courant d'électrons polarisé en spin dans la ligne de référence. On envoie ensuite un courant d'électrons transversal à travers le point mémoire dans lequel on veut écrire, de façon à faire commuter la direction d'aimantation de la couche de stockage en fonction de la direction d'aimantation de la couche de référence par transfert de spin. Ce procédé permet donc de contrôler la direction d'aimantation de la couche de stockage uniquement grâce au contrôle de la direction d'aimantation de la couche de référence en utilisant une seule polarité prédéterminée du courant d'électrons transversal.

Ainsi, le courant d'électrons transversal qui traverse le point mémoire dans lequel on veut écrire peut présenter une polarité constante quelque soit l'information à écrire dans la couche de stockage. En effet, pour orienter la direction d'aimantation de la couche de stockage dans un premier sens, on peut envoyer un premier courant d'électrons polarisé en spin de façon à orienter la direction d'aimantation de la couche de référence dans ce premier sens, puis envoyer un courant d'électrons transversal à travers le point mémoire de façon à ce que ce courant d'électrons transversal favorise l'alignement parallèle de la direction d'aimantation de la couche de stockage et de la direction d'aimantation de la couche de référence. De même, si l'on veut orienter la direction d'aimantation de la couche de stockage dans un deuxième sens, on peut envoyer un deuxième courant d'électrons polarisé en spin de façon à orienter la direction d'aimantation de la couche de référence dans ce deuxième sens, puis à nouveau envoyer le même courant d'électrons transversal à travers le point mémoire de façon à favoriser l'alignement parallèle de la direction d'aimantation de la couche de stockage et de la direction d'aimantation de la couche de référence. Le fait d'envoyer des courants d'électrons transversaux à travers le point mémoire qui présentent tous la même polarité est particulièrement avantageux car cela permet d'avoir des points mémoires de plus petites dimensions grâce à l'utilisation de transistors de sélection unipolaire.

Un autre aspect de l'invention concerne un procédé d'écriture dit « bipolaire » d'une information dans la couche de stockage d'un des points mémoires d'un dispositif magnétique tel que décrit précédemment, le procédé comportant l'étape suivante :
- une étape d'envoi à travers la ligne de référence d'un courant d'électrons polarisé en spin de polarité constante quelque soit l'information à écrire dans la couche de stockage de façon à orienter la direction d'aimantation de la ligne de référence toujours dans la même direction à chaque événement d'écriture ;
- une étape d'envoi à travers le point mémoire d'un courant d'électrons transversal, la polarité du courant d'électrons transversal étant choisie de façon à ce que la direction d'aimantation de la couche de stockage s'aligne soit parallèlement soit antiparallèlement à la direction d'aimantation de la couche de référence.

Ainsi, dans ce procédé d'écriture dit « bipolaire », la couche de référence présente toujours la même direction d'aimantation au moment de l'écriture, quelque soit l'information à écrire dans la couche de stockage. Par contre, la direction d'aimantation de la couche de stockage est contrôlée en faisant varier la polarité du courant d'électrons transversal qui traverse chaque point mémoire.

Un autre aspect de l'invention concerne également un procédé de lecture d'une information stockée dans la couche de stockage d'un des points mémoires d'un dispositif tel que décrit précédemment, le procédé de lecture comportant les étapes suivantes :
- une étape d'envoi d'un premier courant d'électrons polarisé en spin à travers la ligne de référence, le premier courant d'électrons présentant une première polarité choisie de façon à orienter l'aimantation de la ligne de référence dans une première direction ;
- une étape d'envoi d'un courant d'électrons transversal à travers le point mémoire de façon à lire la résistance du point mémoire, ce courant d'électrons transversal de lecture étant d'amplitude inférieure à l'amplitude du courant d'électrons transversal d'écriture pour ne pas risquer de perturber l'information écrite au moment de la lecture du fait du phénomène de transfert de spin ; Le courant d'électrons transversal de lecture présente de préférence une amplitude environ deux fois plus faible que l'amplitude du courant d'électrons transversal d'écriture ;

- une étape d'envoi d'un deuxième courant d'électrons polarisé en spin à travers la ligne de référence, le deuxième courant d'électrons présentant une deuxième polarité choisie de façon à orienter l'aimantation de la ligne de référence dans une deuxième direction ;
- une étape d'envoi d'un courant d'électrons transversal à travers le point mémoire de façon à lire la résistance du point mémoire ;
- une étape de comparaison entre la résistance du point mémoire après l'envoi du premier courant d'électrons polarisé en spin et la résistance du point mémoire après l'envoi du deuxième courant d'électrons polarisé en spin.

D'autres caractéristiques et avantages de l'invention ressortiront à la lecture de la description qui suit, en référence aux figures annexées, qui illustrent :
- la figure 1, une vue en coupe d'un dispositif magnétique selon un premier mode de réalisation de l'invention ;
- la figure 2, une vue en coupe d'un dispositif magnétique selon un deuxième mode de réalisation de l'invention ;
- la figure 3, une vue en coupe du dispositif de la figure 1 lors de l'écriture d'un « 1 » dans la couche de stockage avec un procédé d'écriture monopolaire ;
- la figure 4, une vue en coupe du dispositif de la figure 1 lors de l'écriture d'un « 0 » dans la couche de stockage avec un procédé d'écriture monopolaire;
- la figure 5, une vue en coupe du dispositif de la figure 1 lors de l'écriture d'un « 1 » dans la couche de stockage avec un procédé d'écriture bipolaire;
- la figure 6, une vue en coupe du dispositif de la figure 1 lors de l'écriture d'un « 0 » dans la couche de stockage avec un procédé d'écriture bipolaire;
- la figure 7, une vue en coupe d'un dispositif magnétique selon un autre mode de réalisation de l'invention;
- la figure 8, une vue en coupe d'un dispositif magnétique selon un autre mode de réalisation de l'invention ;
- la figure 9, une vue en coupe d'un dispositif magnétique selon un autre mode de réalisation de l'invention.

Pour plus de clarté, les éléments identiques ou similaires sont repérés par des signes de référence identiques sur l'ensemble des figures.

Sur l'ensemble des figures, les flèches qui portent la référence « D » représentent la direction d'aimantation de la couche sur laquelle elles sont situées. Les flèches notées « I », « I' », représentent les sens de circulation des électrons, lesquels sont opposés aux sens de circulation du courant conventionnel.

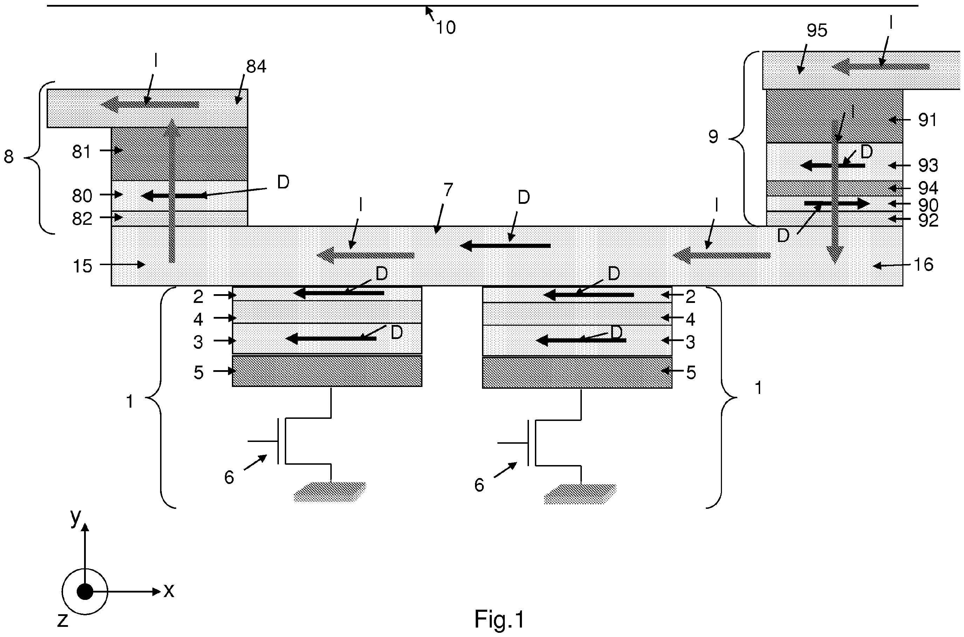

La figure 1 représente un dispositif magnétique selon un mode de réalisation de l'invention.

Ce dispositif magnétique comporte plusieurs points mémoires 1. Sur la figure 1, seuls deux points mémoires 1 sont représentés, mais le dispositif magnétique comporte de préférence plus de deux points mémoires. Le dispositif magnétique peut notamment comprendre 8, 16, 32, 64 points mémoires de façon à pouvoir stocker un mot dans le dispositif magnétique.

Chaque point mémoire 1 comporte une première couche magnétique dite « couche de référence » 2 qui présente une direction d'aimantation variable. La couche de référence 2 peut par exemple être constituée d'une monocouche d'alliage Cobalt-Fer ou Cobalt-Fer-Bore CoFeB voire même d'une bicouche associant une couche de CoFe et une couche de CoFeB.

Chaque point mémoire 1 comporte également une deuxième couche magnétique dite « couche de stockage » 3 dont la direction d'aimantation est variable. La couche de stockage peut par exemple être constituée d'une monocouche d'alliage Cobalt-Fer-Bore CoFeB ou d'une bicouche associant une couche de CoFe et une couche de CoFeB.

Chaque point mémoire 1 comporte également un espaceur 4 qui sépare la couche de référence 2 et la couche de stockage 3. L'espaceur peut par exemple être constitué d'une couche d'oxyde de manganèse MgO qui forme une barrière tunnel entre la couche de référence 2 et la couche de stockage 3. Cet espaceur 4 permet d'obtenir un effet de magnétorésistance entre la couche de stockage 3 et la couche de référence 2. Cette magnétorésistance est la magnétorésistance tunnel si l'espaceur est une barrière tunnel. Elle est une magnétorésistance géante si l'espaceur est une couche métallique non-magnétique comme en cuivre. Cet espaceur peut aussi être une couche isolante percée de chemins conducteurs comme dans les structures dites « à chemins de courant confinés ». L'espaceur permet également de réduire très fortement voire de quasiment annuler le couplage magnétique entre les aimantations des couches de stockage et de référence.

Chaque point mémoire 1 comporte également une couche tampon 5 en contact avec la couche de stockage 3. Cette couche tampon 5 sert de base à la croissance des autres couches du dispositif magnétique. Cette couche tampon 5 est de préférence réalisée dans un matériau non-magnétique. Elle peut par exemple être réalisée dans un alliage nickel-fer-chrome contenant au moins 20% de Cr, ou en nitrure de cuivre ou avoir une structure de multicouche constituée d'une alternance de couches de cuivre, et de couches de tantale. Bien entendu, ces matériaux ne sont donnés qu'à titre illustratif, sans restreindre l'invention.

Chaque point mémoire 1 comporte également des moyens 6 aptes à faire passer un courant d'électrons transversal à travers le point mémoire 1. Ces moyens 6 aptes à faire passer un courant d'électrons transversal à travers le point mémoire 1 peuvent par exemple comporter un transistor qui peut être placé dans une position passante ou dans une position bloquante. Chaque transistor permet ainsi de faire passer de manière contrôlée un courant d'électrons à travers le point mémoire 1 auquel il appartient.

Le dispositif magnétique comporte également une troisième couche magnétique dite « ligne de référence » 7 qui présente une direction d'aimantation variable. La ligne de référence 7 est en contact avec les couches de référence 2 de tous les points mémoires 1 du dispositif magnétique, de sorte que chaque couche de référence 2 est couplée magnétiquement avec la ligne de référence 7 à travers l'interface entre la couche de référence 2 et la ligne de référence 7. La ligne de référence 7 peut par exemple être réalisée en alliage à base de Ni, Fe, Co comme par exemple en Permalloy Ni₈₀Fe₂₀ ou en Co₉₀Fe₁₀ ou Cobalt-Fer-Bore CoFeB. Il est préférable que le matériau utilisé pour cette ligne ait un faible facteur d'amortissement de Gilbert pour que la propagation de paroi induite par phénomène de transfert de spin dans cette ligne se produise à des densités de courant faible de l'ordre de 2.10⁷A/cm² ou moins. La ligne de référence 7 présente de préférence une épaisseur relativement importante, c'est-à-dire supérieure à 4 nm, de préférence de l'ordre de 10 nm. La ligne de référence s'étend suivant une direction longitudinale 10 par rapport au plan des couches.

Le dispositif magnétique comporte également des moyens d'injection aptes à faire circuler dans la ligne de référence 7 un courant d'électrons polarisé en spin qui traverse la ligne de référence 7 de part en part. Le courant d'électrons polarisé en spin traverse donc la ligne de référence 7 longitudinalement suivant la direction 10.

Plus précisément, les moyens d'injections comportent de préférence :
- une alimentation (non représentée) qui est apte à générer un courant d'électrons. Ce courant d'électrons n'est initialement pas polarisé en spin.
- des premiers moyens de circulation d'un courant polarisé en spin 8 et
- des deuxièmes moyens de circulation d'un courant polarisé en spin 9.

Les premiers moyens de circulation d'un courant polarisé en spin 8 comportent de préférence une couche magnétique dite « première couche de polarisation » 80 dont la direction d'aimantation est fixe. Pour cela, les premiers moyens de circulation d'un courant polarisé en spin 8 peuvent par exemple comporter une première couche antiferromagnétique 81 qui permet de fixer la direction d'aimantation de la couche de polarisation 80. Ainsi, lorsque le courant d'électrons issu de l'alimentation traverse la couche de polarisation 80, ce courant d'électrons devient polarisé en spin de par la structure électronique de la couche 80 et notamment grâce aux effets de diffusion électronique dépendante du spin se produisant au sein de cette première couche de polarisation.

Les premiers moyens de circulation de courant polarisé 8 comportent en outre de préférence :
- une première couche non-magnétique 82 disposée entre la couche de polarisation 80 et la première extrémité 15 de la ligne de référence 7 ; Cette première couche non-magnétique 82 a pour effet de découpler magnétiquement l'aimantation de la première couche de polarisation de celle de la ligne de référence de sorte que ces deux aimantations puissent être tantôt parallèles l'une à l'autre, tantôt antiparallèle, au cours du fonctionnement du dispositif ;
- une deuxième couche de métal électriquement conducteur 84 disposée au contact de la première couche antiferromagnétique 81 permettant le passage du courant de l'alimentation électrique vers les premiers moyens de circulation du courant polarisé en spin 8 ;

La première extrémité 15 de la ligne de référence 7 est donc en contact avec la première couche non-magnétique 82, qui elle-même est en contact avec la première couche de polarisation 80, elle-même en contact avec la première couche antiferromagnétique 81, elle-même en contact avec la deuxième couche de métal électriquement conducteur 84.

Les deuxièmes moyens de circulation d'un courant d'électrons polarisé en spin 9 comportent de préférence une couche magnétique dite «deuxième couche de polarisation » 90 dont la direction d'aimantation est fixe et opposée à celle de la première couche de polarisation 80. Afin de réaliser pratiquement cette orientation opposée à celle de la première couche de polarisation 80, on peut adjoindre à cette deuxième couche de polarisation les éléments suivants:
- une couche magnétique dite « couche ferromagnétique d'orientation » 93 de moment magnétique supérieur à celui de la deuxième couche de polarisation 90. Cette couche ferromagnétique d'orientation peut être par exemple en CoFe d'épaisseur de 5 à 10nm.
- une première couche de couplage antiferromagnétique 94 permettant d'induire un alignement antiparallèle de l'aimantation de la couche ferromagnétique d'orientation 93 avec l'aimantation de la deuxième couche de polarisation 90, la première couche de couplage antiferromagnétique 94 étant située entre la couche ferromagnétique d'orientation 93 et la deuxième couche de polarisation 90. La première couche de couplage antiferromagnétique 94 peut être par exemple en ruthénium d'épaisseur entre 0.5 et 0.9nm ;
- une deuxième couche antiferromagnétique 91 de même nature que la première couche antiferromagnétique 81 utilisée pour le piégeage de la première couche de polarisation 80. La deuxième couche antiferromagnétique 91 permet le piégeage de l'aimantation de cette couche ferromagnétique d'orientation 93 et permet ainsi de façon indirecte, le piégeage de la deuxième couche de polarisation 90 via le couplage antiferromagnétique à travers la première couche de couplage antiferromagnétique 94.

Le but de l'introduction de la couche ferromagnétique d'orientation 93 et de la deuxième quatrième couche antiferromagnétique 91 est de permettre l'orientation des aimantations de la première couche de polarisation 80 et de la deuxième couche de polarisation 90 dans des directions opposées. En effet lors d'un recuit au-dessus de la température de blocage des couches antiferromagnétiques 81 et 91 dans un champ modéré, il est possible d'orienter l'aimantation de la première couche de polarisation 80 parallèlement au champ modéré appliqué ainsi que celle de la couche ferromagnétique d'orientation 93. Par « champ modéré », on entend un champ magnétique suffisamment fort pour orienter l'aimantation de la première couche de polarisation 80 et celle de la couche ferromagnétique d'orientation 93 dans la direction du champ magnétique mais qui n'est pas trop fort pour ne pas vaincre le couplage antiferromagnétique entre la couche ferromagnétique d'orientation 93 et la deuxième couche de polarisation 90 c'est-à-dire que le champ magnétique appliqué est inférieur au champ dit de « spin-flop » de la structure constituée par la deuxième couche de polarisation 90, la première couche de couplage antiferromagnétique 94 et la couche ferromagnétique d'orientation 93.

Dans ce document on appelle « champ de « spin-flop » », le champ auquel deux couches magnétiques couplées antiferromagnétiquement soumises à un champ magnétique transitent d'une situation à champ faible, c'est-à-dire en dessous du champ de spin-flop, où leurs aimantations sont orientées antiparallèlement vers une situation à champ fort, c'est-à-dire au dessus du champ de spin-flop, où leurs aimantations forment entre elles un angle inférieur à 180° degrés et se fermant progressivement jusqu'à devenir parallèles lorsque le champ excède le champ de saturation. Comme le moment magnétique de la couche d'orientation 93 a été ici choisi supérieur à celui de la deuxième couche de polarisation 90, l'aimantation de la couche d'orientation 93 va s'orienter parallèlement à la direction du champ modéré appliqué et celle de la deuxième couche de polarisation 90 va s'orienter antiparallèlement à la direction du champ modéré appliqué. Ainsi à l'issue du refroidissement sous champ modéré depuis une température supérieure à la température de blocage de la première couche antiferromagnétique 81 et de la deuxième couche antiferromagnétique 91 jusqu'à la température ambiante, l'aimantation de la première couche de polarisation 80 se trouvera piégée parallèlement à la direction du champ modéré tandis que l'aimantation de la deuxième couche de polarisation 90 se trouvera piégée en direction opposée à celle du champ modéré appliqué pendant le refroidissement.

Les deuxièmes moyens de circulation d'un courant polarisé en spin 9 comprennent en outre de préférence:
- une troisième couche non-magnétique 92 disposée entre la deuxième couche de polarisation 90 et la deuxième extrémité 16 de la ligne de référence 7. Cette troisième couche non-magnétique 92 a pour but de découpler magnétiquement, en l'absence de courant, l'aimantation de la deuxième couche de polarisation 90 de celle de l'aimantation de la ligne de référence 7;
- une quatrième couche de métal électriquement conducteur 95 disposée au contact de la deuxième couche antiferromagnétique 91.

Ces couches de métaux conducteurs électriquement 82, 84, 92 et 95 permettent le passage du courant d'électrons à travers la ligne de référence 7. Ces couches de métaux conducteurs électriquement 82, 84, 92 et 95 peuvent par exemple être constituées de cuivre.

La deuxième extrémité 16 de la ligne de référence 7 est donc en contact avec la troisième couche non-magnétique 92, qui elle-même est en contact avec la deuxième couche de polarisation 90, elle-même en contact avec la première couche de couplage antiferromagnétique 94, elle-même en contact avec la couche ferromagnétique d'orientation 93, elle-même en contact avec la deuxième couche antiferromagnétique 91, elle-même en contact avec la quatrième couche de métal électriquement conducteur 95.

Selon différents modes de réalisation, la couche de métal électriquement conducteur 84 et la couche de métal électriquement conducteur 95 peuvent être une seule et même couche qui est gravée en son centre, ou deux couches réalisées indépendamment l'une de l'autre.

On peut modifier la direction d'aimantation de la ligne de référence 7, et donc de la couche de référence 2 de chaque élément mémoire 1, en envoyant un courant d'électrons polarisé en spin à travers la ligne de référence 7 dans un sens choisi. Le sens du courant polarisé en spin envoyé dans la ligne de référence 7 est choisi de sorte que le couple de transfert de spin exercé par ce courant tende à faire commuter l'aimantation de la ligne de référence 7 en sens opposé du sens initial. Si l'aimantation de la première couche de polarisation 80 est opposée à l'aimantation initiale de la ligne de référence 7 alors on envoie le courant d'électrons de la première couche de polarisation 80 vers la ligne de référence 7 donc le courant conventionnel circule de la ligne de référence 7 vers la première couche de polarisation 80. Si par contre l'aimantation de la première couche de polarisation 80 est initialement parallèle à celle de la ligne de référence 7 comme représenté sur la Figure 1 alors le courant d'électrons circulera de la ligne de référence 7 vers la première couche de polarisation 80 comme indiqué sur la Figure 1.

L'effet de la circulation du courant d'électrons polarisé en spin dans la ligne de référence 7 dans la direction indiquée ci-dessus relativement à la direction de l'aimantation initiale de la ligne de référence, est tout d'abord de nucléer deux domaines magnétiques sous les moyens de circulation de courant polarisé en spin 8 et 9. Ces domaines, au moment de leur nucléation, sont aimantés dans une direction opposée au reste de la ligne de référence. Lorsque les électrons circulent longitudinalement à travers la ligne de référence 7, ils repoussent les parois de ces domaines magnétiques dans leur direction de propagation. Ainsi, le domaine qui se trouve en amont du courant d'électrons va s'étendre par propagation de la paroi séparant ce domaine du reste de l'aimantation de la couche de référence, dans la direction d'écoulement des électrons. La paroi se propage ainsi le long de la ligne de référence sous l'effet du transfert de spin exercé par les électrons polarisés en spin sur la paroi. La paroi se déplace typiquement à des vitesses de 100 à 1000nm/ns. En conséquence, si la ligne de référence fait quelques centaines de nanomètres de long, la paroi va mettre quelques nanosecondes à se propager d'une extrémité vers l'extrémité opposée. Une fois que la paroi s'est propagée jusqu'à l'extrémité opposée où elle rejoint le deuxième domaine nucléé, alors l'ensemble de la ligne de référence présente la nouvelle direction d'aimantation voulue. En choisissant le sens du courant qui parcourt la ligne de référence 7, on peut donc contrôler la direction d'aimantation de la ligne de référence et donc de la couche de référence 2 de chaque point mémoire 1. Le fait de modifier la direction d'aimantation de la couche de référence 2 grâce à l'injection d'un courant d'électrons polarisés en spin dans la ligne de référence 7 est particulièrement avantageux car cela permet d'utiliser des courants de très faible intensité, de l'ordre de la dizaine ou quelques dizaines de microampères.

En outre, le fait de changer la direction d'aimantation de la couche de référence 2 grâce à un courant d'électrons polarisé en spin qui parcourt la ligne de référence 7 permet de modifier la direction d'aimantation de la couche de référence 2 sans risquer de modifier la direction d'aimantation de la couche de stockage 3 par erreur.

Le dispositif magnétique de la figure 1 permet une lecture différentielle de l'information contenue dans la couche de stockage. Pour cela, on envoie un premier courant d'électrons polarisé en spin à travers la ligne de référence 7, le premier courant d'électrons polarisé en spin présentant une première polarité choisie de façon à orienter l'aimantation de la ligne de référence 7 dans une première direction. Les couches de références 2 des points mémoires 1 en contact avec la ligne de référence 7 présentent alors la même direction d'aimantation que la ligne de référence 7. On envoie alors un courant d'électrons transversal I" à travers chaque point mémoire 1 de façon à lire la résistance de chacun des points mémoires 1. Ce courant d'électrons transversal I" de lecture est d'amplitude inférieure, typiquement par un facteur 2, au courant d'électrons transversal d'écriture pour ne pas risquer de perturber l'information écrite au moment de la lecture du fait du phénomène de transfert de spin. Les potentiels sur les conducteurs 84 et 95 sont appliqués à l'aide de l'alimentation électrique de sorte que ce courant d'électrons transversal traverse l'élément mémoire 1 et s'écoule dans la ligne de référence 7 dans la direction correspondant à la première polarité qui a été choisie de façon à orienter l'aimantation de la ligne de référence 7 dans une première direction. Ce chemin d'écoulement du courant permet d'éviter de déstabiliser l'orientation de l'aimantation de la ligne de référence et des couches de référence lors de la lecture sous l'effet de la circulation du courant d'électrons I" dans la ligne de référence 7.

On envoie ensuite un deuxième courant d'électrons polarisé en spin à travers la ligne de référence 7, le deuxième courant d'électrons présentant une deuxième polarité choisie de façon à orienter l'aimantation de la ligne de référence 7 dans une deuxième direction. Les couches de références 2 des points mémoires 1 en contact avec la ligne de référence 7 présentent alors la même direction d'aimantation que la ligne de référence 7. On envoie ensuite un courant d'électrons transversal à travers chaque point mémoire 1 de façon à lire la résistance du point mémoire. Les potentiels sur les conducteurs 84 et 95 sont appliqués à l'aide de l'alimentation électrique de sorte que ce courant d'électrons transversale traverse l'élément mémoire 1 et s'écoule dans la ligne de référence 7 dans la direction correspondant à la deuxième polarité qui a été choisie de façon à orienter l'aimantation de la ligne de référence 7 dans une deuxième direction. Ce chemin d'écoulement du courant permet d'éviter de déstabiliser l'orientation de l'aimantation de la ligne de référence 7 et des couches de référence 2 lors de la lecture sous l'effet de la circulation du courant d'électrons I" dans la ligne de référence 7.

On compare ensuite la résistance de chaque point mémoire après l'envoi du premier courant d'électrons polarisé en spin et après l'envoi du deuxième courant d'électrons polarisé en spin et on en déduit la direction d'aimantation de la couche de stockage 2 de chaque point mémoire 1.

. Ce mode de lecture des points mémoires est particulièrement avantageux car il permet une lecture plus fiable de l'information contenue dans les couches de stockage 3 et plus tolérante aux dispersions de résistance et de magnétorésistance d'un point mémoire à l'autre. Par ce mode de lecture, chaque point mémoire est en effet auto-référencé.

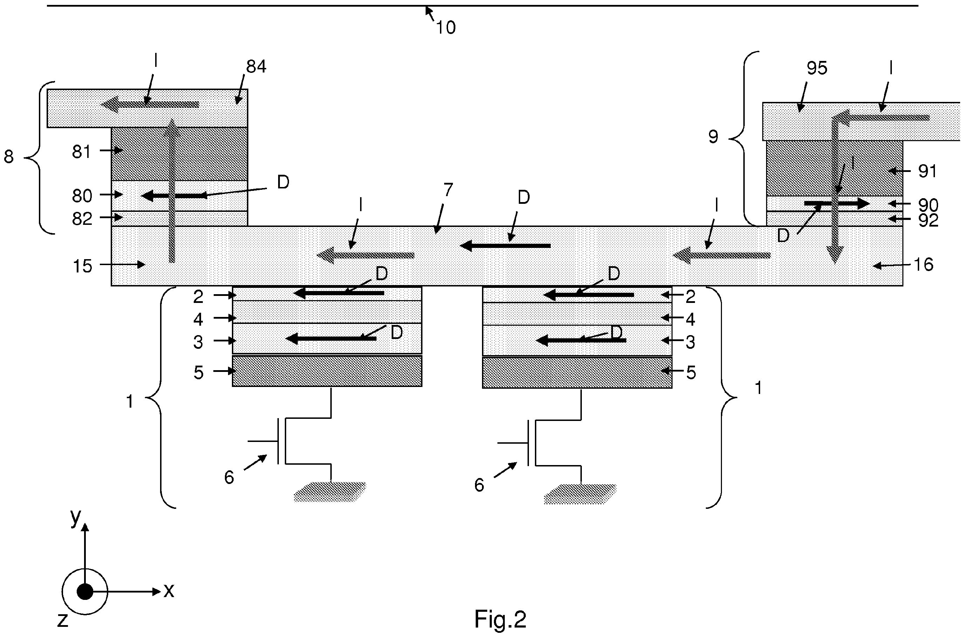

Un deuxième mode de réalisation du dispositif selon l'invention est décrit en référence à la figure 2. La différence par rapport au premier mode de réalisation se situe au niveau des deuxièmes moyens de circulation d'un courant polarisé en spin 9. Dans ce deuxième mode de réalisation, ces deuxièmes moyens de circulation d'un courant polarisé en spin 9 comprennent une deuxième couche de polarisation 90 dont l'aimantation est fixe et de direction opposée à celle de la première couche de polarisation. Afin de réaliser pratiquement cette orientation opposée à celle de la première couche de polarisation 80, les deuxièmes moyens de circulation d'un courant d'électrons polarisés en spin comportent une troisième couche antiferromagnétique 91 de température de blocage différente de celle de la première couche antiferromagnétique 81. Par exemple, cette troisième couche antiferromagnétique 91 peut être en PtMn d'épaisseur 15nm dont la température de blocage est de 300°C alors que la première couche antiferromagnétique peut être en IrMn d'épaisseur 7nm dont la température de blocage est 230°C. Le principe pour aligner les aimantations des deux couches de polarisation en direction opposée est alors le suivant. Supposons, sans nuire à la généralité, que la température de blocage de la troisième couche antiferromagnétique 91 soit supérieure à celle de la première couche antiferromagnétique 81. On chauffe alors le dispositif à une température légèrement supérieure à la température de blocage de la troisième couche antiferromagnétique 91 en appliquant un champ magnétique suffisamment fort pour polariser l'aimantation de la deuxième couche de polarisation 90 dans sa direction. On refroidit alors le dispositif dans ce champ jusqu'à la température de blocage de la première couche antiferromagnétique 81. On renverse alors le champ magnétique dans la direction opposée, le champ étant suffisamment fort pour polariser l'aimantation de la première couche de polarisation 80 dans la direction du champ magnétique. On refroidit alors le dispositif jusqu'à la température ambiante dans ce champ magnétique. A l'issue de cette opération les aimantations des deux couches de polarisation 80 et 90 se trouvent piégées dans des directions opposées.

Les deuxièmes moyens de circulation de courant polarisé en spin comprennent en outre les mêmes couches de métaux électriquement conducteurs 92 et 95 que dans le premier mode de réalisation.

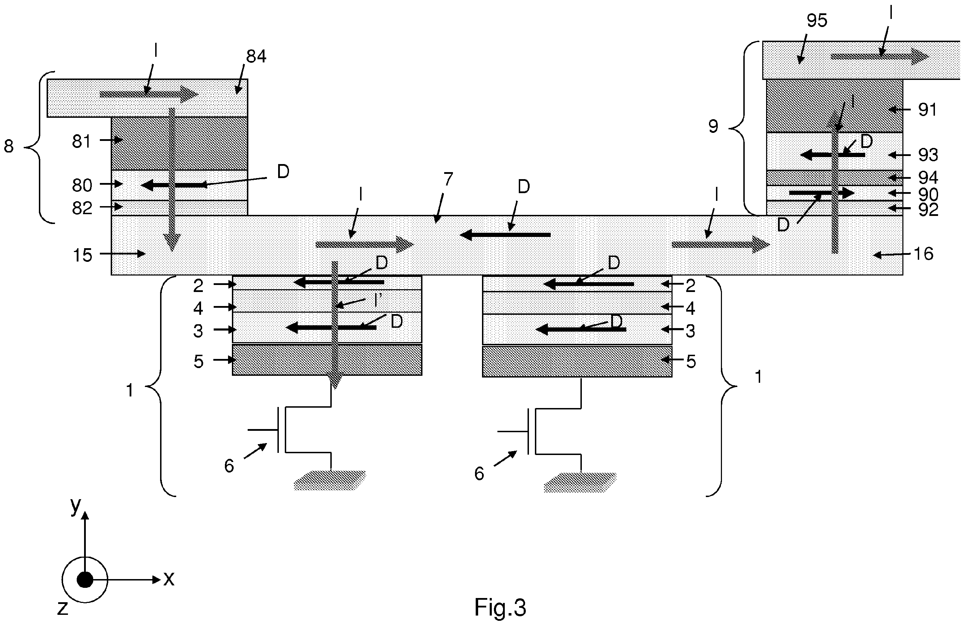

Un procédé d'écriture monopolaire d'un « 1 » dans la couche de stockage 3 d'un des points mémoires du dispositif magnétique de la figure 1 va maintenant être décrit en référence à la figure 3.

Pour qu'un « 1 » soit stocké dans la couche de stockage 3, supposons que la direction d'aimantation de la couche de stockage 3 doive être dirigée suivant l'axe (-x).

Afin de parvenir à ce résultat, un courant d'électrons est tout d'abord injecté dans la première extrémité 15 de la ligne de référence 7 grâce à l'alimentation. Lorsque ce courant d'électrons traverse la première couche de polarisation 80, les électrons de ce courant d'électrons I se polarisent en spin de sorte qu'un courant d'électrons polarisés en spin est injecté dans la première extrémité 15 de la ligne de référence 7. Comme l'aimantation de la première couche de polarisation 80 est supposée être orientée suivant la direction (-x), la direction de polarisation en spin des électrons après traversée de la première couche de polarisation 80 est aussi la direction (-x). Ainsi, le courant d'électrons polarisé en spin permet d'orienter l'aimantation de la ligne de référence 7 suivant l'axe (-x) comme représenté sur la Figure 3, ce qui a pour effet d'aligner l'aimantation de la couche de référence 2 du point mémoire 1 suivant la direction (-x) également, puisque la ligne de référence 7 et la couche de référence 2 sont couplées magnétiquement à travers leur interface commune.

Le transistor du point mémoire 1 est ensuite rendu passant de façon à ce qu'un courant d'électrons dit « courant d'électrons transversal » l' traverse le point mémoire 1. Ce courant d'électrons transversal I' a une polarité choisie de façon à ce qu'il favorise par exemple l'alignement parallèle des directions d'aimantation de la couche de référence 2 et de la couche de stockage 3. Pour cela, les électrons circulent de la couche de référence 2 vers la couche de stockage 3, le courant conventionnel circulant en direction opposée. Pendant cette opération, les potentiels sur les conducteurs 84 et 95 sont appliqués à l'aide de l'alimentation électrique de sorte que ce courant d'électrons transversal traverse l'élément mémoire 1 et s'écoule dans la ligne de référence 7 à partir des premiers moyens d'injection d'un courant polarisé en spin (8) jusqu'au point mémoire considéré (1) selon la direction (+x). Ce chemin d'écoulement du courant permet d'éviter de déstabiliser l'orientation de l'aimantation de la ligne de référence et de la couche de référence 2 lors de l'écriture monopolaire du point mémoire sous l'effet de la circulation du courant d'électrons I' dans la ligne de référence 7.

Suite à l'envoi de ce courant d'électrons transversal I' à travers le point mémoire 1, la couche de stockage 3 présente donc une direction d'aimantation suivant l'axe (-x).

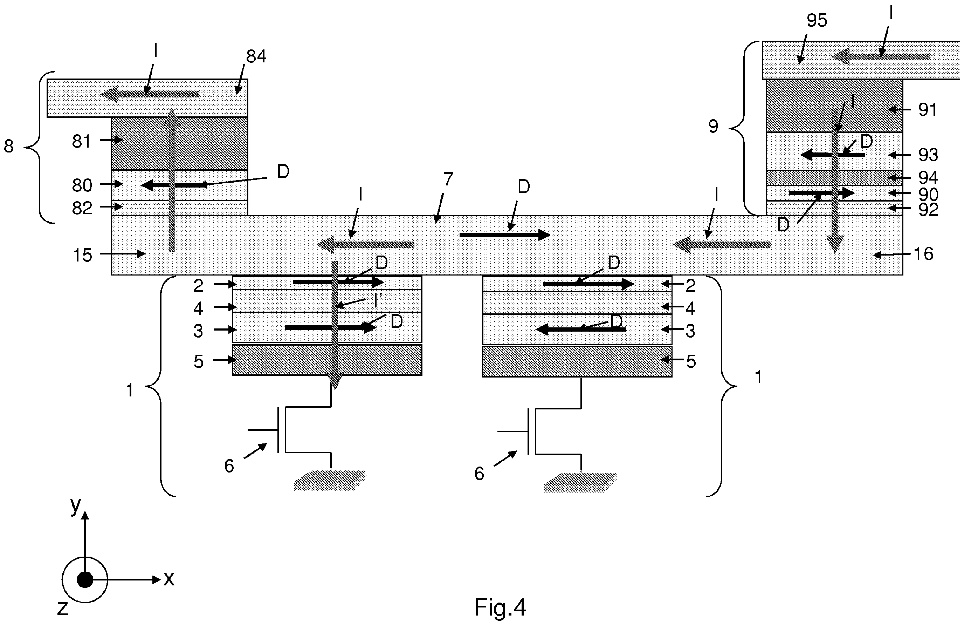

Un procédé d'écriture monopolaire d'un « 0 » dans la couche de stockage 3 d'un des points mémoires du dispositif magnétique de la figure 1 va maintenant être décrit en référence à la figure 4.

Pour qu'un « 0 » soit stocké dans la couche de stockage 3, la direction d'aimantation de la couche de stockage 3 doit être dirigée suivant l'axe (+x).

Afin de parvenir à ce résultat, un courant d'électrons I est tout d'abord injecté dans la deuxième extrémité 16 de la ligne de référence 7 grâce à l'alimentation. Lorsque ce courant d'électrons traverse la deuxième couche de polarisation 90, les électrons de ce courant d'électrons se polarisent en spin de sorte qu'un courant d'électrons polarisés en spin I est injecté dans la deuxième extrémité 16 de la ligne de référence 7. Ce courant d'électrons polarisé en spin I permet d'orienter l'aimantation de la ligne de référence 7 suivant l'axe (+x), ce qui a pour effet d'aligner l'aimantation de la couche de référence 2 du point mémoire 1 suivant la direction (+x) également, puisque la ligne de référence 7 et la couche de référence 2 sont couplées magnétiquement.

Le transistor du point mémoire 1 est ensuite ouvert de façon à ce qu'un courant d'électrons transversal I' traverse le point mémoire. Ce courant d'électrons transversal I' a une polarité choisie comme décrit juste précédemment pour l'écriture d'un « 1 » logique de façon à ce qu'il favorise l'alignement parallèle des directions d'aimantation de la couche de référence 2 et de la couche de stockage 3. Pendant cette opération, les potentiels sur les conducteurs 84 et 95 sont appliqués à l'aide de l'alimentation électrique de sorte que ce courant d'électrons transversal traverse l'élément mémoire 1 et s'écoule dans la ligne de référence 7 à partir des deuxièmes moyens d'injection d'un courant polarisé en spin 9 jusqu'au point mémoire considéré 1 selon la direction (-x). Ce chemin d'écoulement du courant permet d'éviter de déstabiliser l'orientation de l'aimantation de la ligne de référence 7 et de la couche de référence 2 lors de l'écriture monopolaire du point mémoire 1 sous l'effet de la circulation du courant d'électrons I' dans la ligne de référence 7. Suite à l'envoi de ce courant d'électrons transversal I' à travers le point mémoire 1, la couche de stockage 3 présente donc une direction d'aimantation suivant l'axe (+x).

Ainsi, que ce soit pour écrire un « 1 » ou un « 0 » dans la couche de stockage, un courant d'électrons transversal I' qui favorise l'alignement parallèle des directions d'aimantations des couches de stockage 3 et de référence 2 est envoyé à travers le point mémoire 1. Le dispositif magnétique permet donc d'écrire dans la couche de stockage 3 avec un courant d'électrons transversal I' unipolaire, ce qui permet d'avoir des points mémoires de plus petites dimensions grâce à l'utilisation de transistors de sélection unipolaire.

La description du procédé monopolaire en référence aux figures 3 et 4 a été faite dans le cas où le courant d'électrons transversal I' favorise l'alignement parallèle des aimantations des couches de stockage et de référence ; toutefois on pourrait également choisir d'utiliser le procédé d'écriture monopolaire avec un courant d'électrons transversal I' de polarité opposée qui favorise l'alignement antiparallèle des aimantations des couches de stockage et de référence sans sortir du cadre de l'invention.

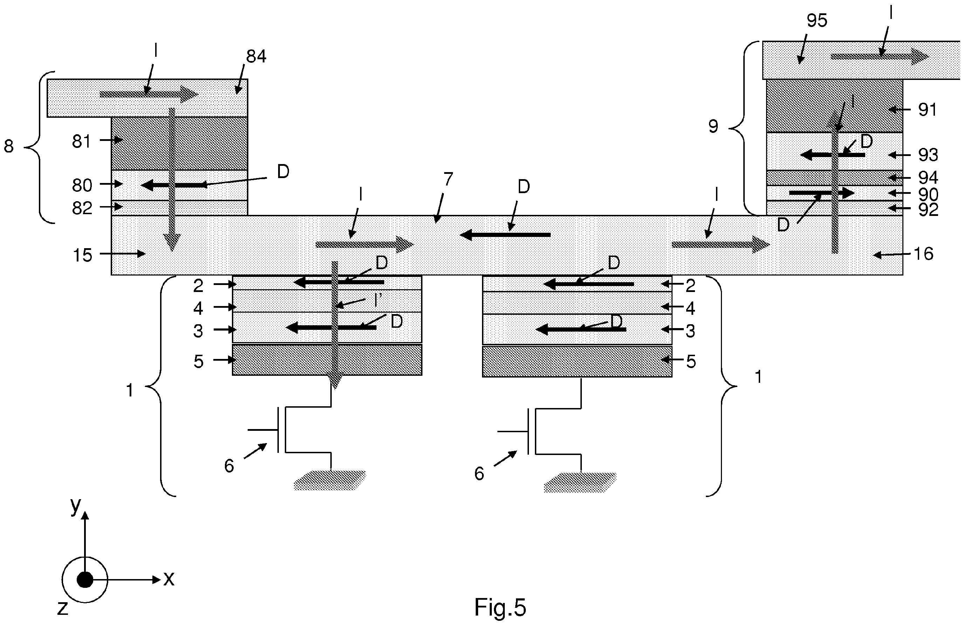

Un procédé d'écriture bipolaire d'un « 1 » dans la couche de stockage 3 d'un des points mémoires du dispositif magnétique de la figure 1 va maintenant être décrit en référence à la figure 5.

Pour qu'un « 1 » soit stocké dans la couche de stockage 3, nous supposons toujours que la direction d'aimantation de la couche de stockage 3 doive être dirigée suivant l'axe (-x).

Cette fois, quelque soit l'information à écrire dans la couche de stockage 3, la direction d'aimantation de la ligne de référence 7 et donc de la couche de référence 2 restera inchangée, mais ce sera la polarité du courant d'électrons transversal I' qui variera suivant que l'on veut écrire un « 1 » ou un « 0 » dans la couche de stockage 3.

Ainsi, à chaque événement d'écriture, on peut choisir d'orienter l'aimantation de la ligne de référence 7, et donc la couche de référence 2 de chaque point mémoire 1 couplé à cette ligne de référence suivant l'axe (-x). Pour cela, on fait circuler un premier courant d'électrons I des premiers moyens d'injection d'un courant polarisé en spin 8 vers la ligne de référence 7 comme indiqué sur la Figure 5. Ensuite, pour écrire un « 1 » logique, on fait circuler un courant d'électrons transversal I' à travers le point mémoire 1 en choisissant la polarité de ce courant d'électrons transversal telle que ce courant d'électrons transversal I' favorise l'alignement parallèle des directions d'aimantations des couches de référence 2 et de stockage 3. Pendant cette opération, les potentiels sur les conducteurs 84 et 95 sont appliqués à l'aide de l'alimentation électrique de sorte que ce courant d'électrons transversal traverse l'élément mémoire 1 et s'écoule dans la ligne de référence 7 à partir des premiers moyens d'injection d'un courant polarisé en spin 8 jusqu'au point mémoire considéré 1 selon la direction (+x). Ce chemin d'écoulement du courant permet d'éviter de déstabiliser l'orientation de l'aimantation de la ligne de référence et de la couche de référence 2 lors de l'écriture bipolaire du point mémoire sous l'effet de la circulation du courant d'électrons I' dans la ligne de référence 7.

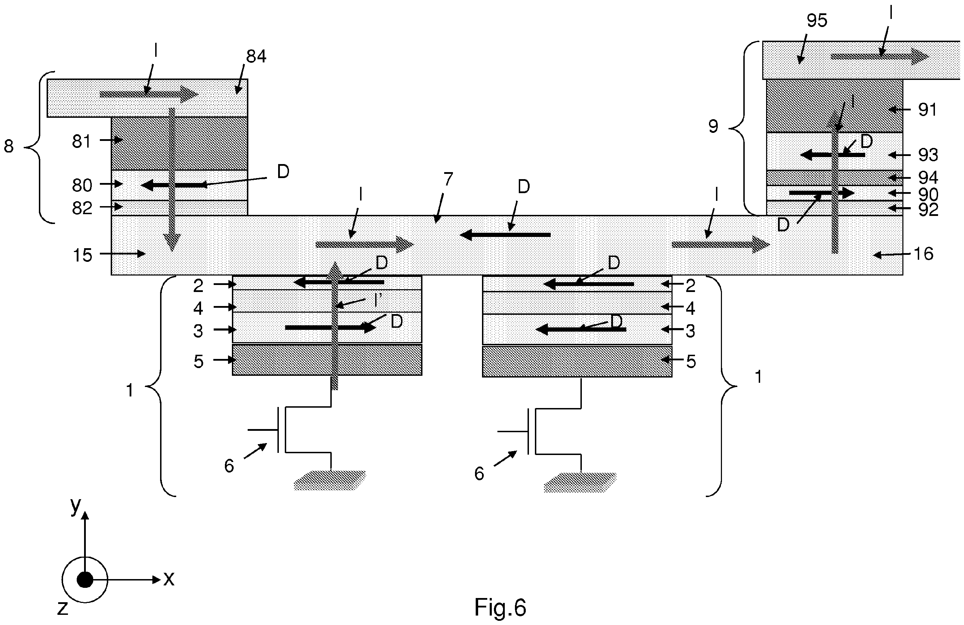

Un procédé d'écriture bipolaire d'un « 0 » dans la couche de stockage 3 d'un des points mémoires du dispositif magnétique de la figure 1 va maintenant être décrit en référence à la figure 6.

Pour qu'un « 0 » soit stocké dans la couche de stockage 3, la direction d'aimantation de la couche de stockage 3 doit être dirigée suivant l'axe (+x).

Comme juste précédemment pour l'écriture d'un « 1 » logique, on commence par orienter l'aimantation de la ligne de référence 7, et donc la couche de référence 2 de chaque point mémoire 1 couplé à cette ligne de référence 7 suivant l'axe (-x). Pour cela, on fait circuler un premier courant d'électrons I des premiers moyens d'injection d'un courant polarisé en spin 8 vers la ligne de référence 7 comme indiqué sur la Figure 6. Ensuite, pour écrire un « 0 » logique, on fait circuler un courant d'électrons transversal I' à travers le point mémoire 1 en choisissant la polarité de ce courant d'électrons transversal telle que ce courant d'électrons transversal I' favorise l'alignement antiparallèle des directions d'aimantations des couches de référence 2 et de stockage 3. Pendant cette opération, les potentiels sur les conducteurs 84 et 95 sont appliqués à l'aide de l'alimentation électrique de sorte que ce courant d'électrons transversal traverse l'élément mémoire 1 et s'écoule dans la ligne de référence 7 à partir du point mémoire considéré 1 vers les deuxièmes moyens d'injection d'un courant polarisé en spin 9 selon la direction (+x). Ce chemin d'écoulement du courant permet d'éviter de déstabiliser l'orientation de l'aimantation de la ligne de référence et de la couche de référence 2 lors de l'écriture bipolaire du point mémoire sous l'effet de la circulation du courant d'électrons I' dans la ligne de référence 7.

Ainsi, dans un procédé d'écriture bipolaire d'une information dans la couche de stockage, la direction d'aimantation de la ligne de référence est constante quelque soit l'information à écrire, et c'est la polarité du courant d'électrons transversal qui varie pour faire varier la direction d'aimantation de la couche de stockage. Ceci est l'opposé du procédé d'écriture monopolaire d'une information dans la couche de stockage 3 décrit précédemment, pour lequel la polarité du courant d'électrons transversal est constante quelque soit l'information à écrire et c'est la direction d'aimantation de la ligne de référence qui varie pour faire varier la direction d'aimantation de la couche de stockage.

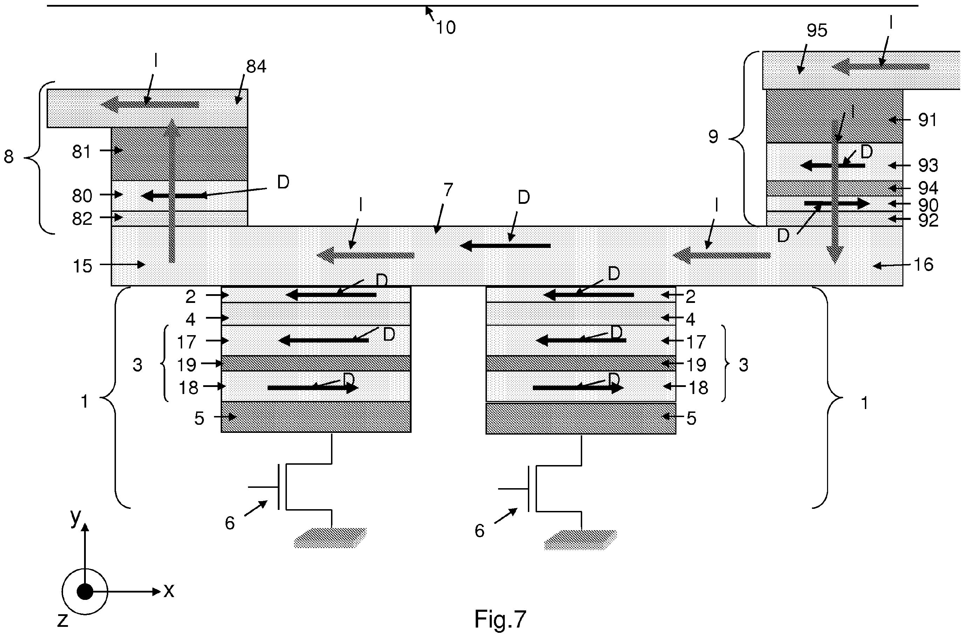

La figure 7 représente un dispositif magnétique selon un autre mode de réalisation dans lequel la couche de stockage 3 est constituée d'un empilement tricouche antiferromagnétique synthétique. La couche de stockage 3 est donc constituée de deux couches magnétiques 17 et 18 séparées par une couche de couplage antiferromagnétique 19, les deux couches magnétiques 17, 18 étant couplées antiparallèlement à travers la couche de couplage antiferromagnétique 19. Les deux couches magnétiques 17 et 18 peuvent par exemple être constituées d'alliage Cobalt-Fer CoFe ou Cobalt-Fer-Bore CoFeB. La couche de couplage antiferromagnétique 19 peut par exemple être constituée de ruthénium Ru d'épaisseur de préférence comprise entre 0.5 nm et 0.9 nm. Les moments magnétiques des deux couches magnétiques 17 et 18 de l'empilement tricouche antiferromagnétique synthétique sont de préférence choisis sensiblement égaux de sorte que le moment total de l'empilement tricouche antiferromagnétique synthétique est proche de zéro. Ce mode de réalisation est avantageux car il permet d'avoir une aimantation plus uniforme et il permet d'avoir une plus grande stabilité thermique puisque le volume de la couche de stockage est plus important. Il permet aussi de minimiser les effets d'interaction magnétostatique entre la couche de stockage 3 et la ligne de référence 7 et la couche de référence 2. La direction d'aimantation d'un tel empilement tricouche peut être modifiée par transfert de spin, c'est-à-dire que les aimantations des couches magnétiques qui constituent l'empilement tricouche, tout en restant antiparallèles entre elles, peuvent être commutées d'une direction à la direction opposée sous l'effet d'un courant d'électrons traversant le point mémoire.

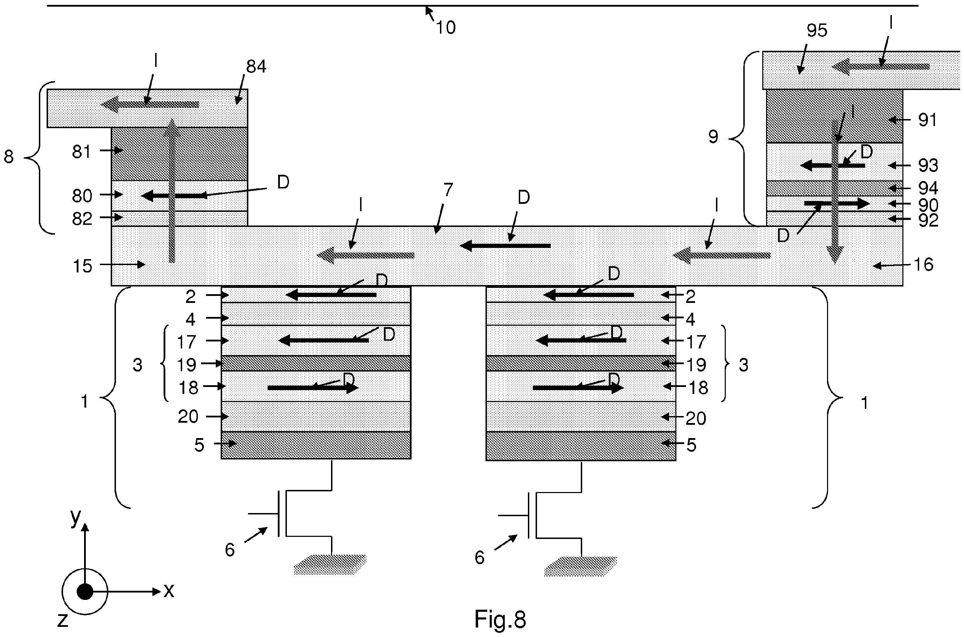

La figure 8 représente un autre mode de réalisation dans lequel chaque point mémoire 1 comporte en outre une deuxième couche antiferromagnétique 20 disposée entre la couche tampon 5 et la couche de stockage 3. La couche de stockage 3 peut être constituée d'un empilement tricouche antiferromagnétique synthétique, comme représenté sur la figure 7, ou bien d'une monocouche. La deuxième couche antiferromagnétique 20 présente de préférence une température de blocage modérée, c'est-à-dire de l'ordre de 200 à 250°C. La deuxième couche antiferromagnétique 20 peut par exemple être constituée d'alliage Fer-Manganèse FeMn, d'alliage Iridium-Manganèse IrMn ou encore d'alliage Iridium-Manganèse-Chrome IrMnCr. La deuxième couche antiferromagnétique 20 permet de piéger la direction d'aimantation de la couche de stockage 3 lorsque l'on ne veut pas écrire dans la couche de stockage 3. Par contre, pour écrire dans la couche de stockage, un courant d'électrons transversal est envoyé à travers le point mémoire 1. Ce courant d'électrons transversal présente une intensité suffisante pour provoquer un échauffement de la deuxième couche antiferromagnétique 20 au-delà de sa température de blocage par effet Joule au niveau de la barrière tunnel 4. La deuxième couche antiferromagnétique 20 libère alors la direction d'aimantation de la couche de stockage 3. En outre, ce courant d'électrons transversal permet un transfert de spin de la couche de référence 2 vers la couche de stockage 3, ce qui conduit à une commutation de la direction d'aimantation de la couche de stockage 3 dans la direction voulue. Le courant d'électrons transversal est ensuite stoppé, en rendant le transistor 6 bloquant. La deuxième couche antiferromagnétique 20 se refroidit et piège alors à nouveau la direction d'aimantation de la couche de stockage 3.

Dans les modes de réalisation des figures 1 à 8, les aimantations des couches magnétiques sont comprises dans le plan de ces couches magnétiques. En d'autres termes, dans les modes de réalisation des figures 1 à 8, les couches magnétiques s'étendent dans des plans parallèles au plan (xz) et l'aimantation des couches magnétiques est également parallèle au plan (xz). Une telle aimantation est dite « dans le plan ».

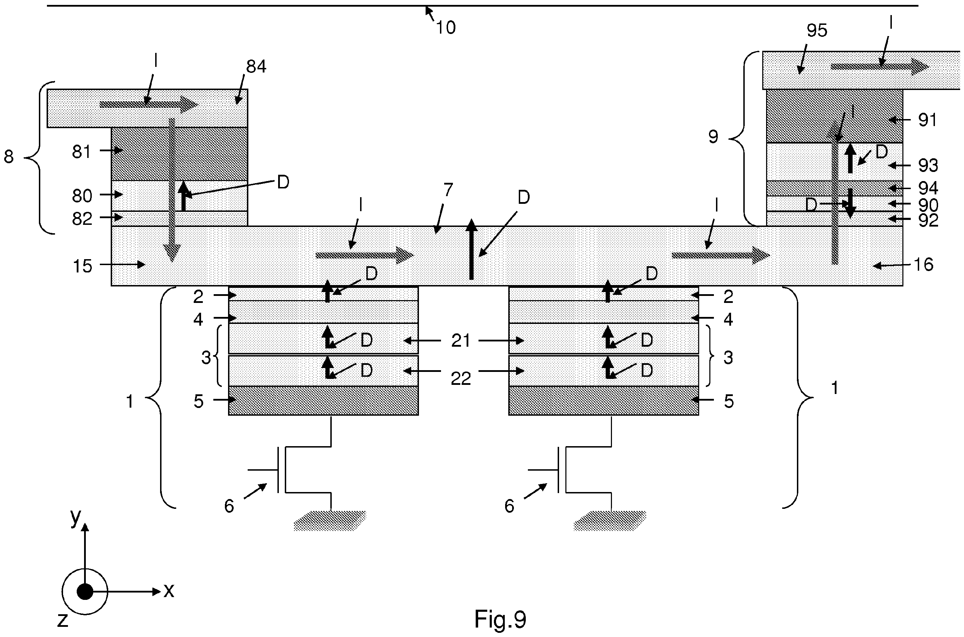

Toutefois, l'invention n'est pas limitée aux aimantations « dans le plan ». Ainsi, la figure 9 représente un dispositif magnétique selon un autre mode de réalisation de l'invention dans lequel les couches magnétiques présentent une direction d'aimantation « hors du plan », c'est-à-dire que les couches magnétiques sont parallèles au plan (xz), tandis que l'aimantation des couches magnétiques est parallèle à l'axe y qui est perpendiculaire au plan (xz). Dans ce cas la couche de stockage doit comporter de préférence une première couche magnétique de stockage 21 et une couche de transition 22 disposée entre la première couche magnétique de stockage 21 et la couche tampon 5. La première couche magnétique de stockage 21 peut par exemple être constituée d'un alliage Cobalt-Fer-Bore CoFeB, tandis que la couche de transition 22 peut être constituée d'un alliage Cobalt-Palladium ou Co-Pt ou d'un multicouche (Co/Pd) ou (Co/Pt). La ligne de référence 7 et les couches de polarisation 80 et 90 peuvent également être constituées d'un alliage Cobalt-Palladium CoPd ou multicouche (Co/Pd). La couche de référence 2 peut être constituée d'un alliage Cobalt-Fer-Bore CoFeB ou d'un ensemble de deux couches couplées comprenant une fiche couche de CoFeB d'épaisseur typiquement 1 nm au contact de l'espaceur 4 surmontée d'un alliage CoPd ou d'une multicouche (Co/Pd).

Naturellement, l'invention n'est pas limitée aux modes de réalisation décrits en référence aux figures et des variantes peuvent être envisagées sans sortir du cadre de l'invention. En particulier, les matériaux et les épaisseurs choisis pour réaliser les couches tampon, les couches de référence, les couches de stockage et les espaceurs ne sont donnés ici qu'à titre illustratif et d'autres matériaux ou épaisseurs pourraient être utilisés.

## Revendications

1. Dispositif magnétique comportant :
- au moins deux points mémoires (1), chaque point mémoire comportant :
∘ une première couche magnétique dite « couche de référence » (2), la couche de référence (2) présentant une direction d'aimantation variable ;
∘ une deuxième couche magnétique dite « couche de stockage » (3), la couche de stockage (3) présentant une direction d'aimantation variable ;
∘ un espaceur (4) qui sépare la couche de référence (2) et la couche de stockage (3), la couche de référence (2) et la couche de stockage (3) étant découplées magnétiquement à travers l'espaceur (4) ;
∘ des moyens aptes à faire passer un courant d'électrons transversal à travers le point mémoire (1) ;
le dispositif magnétique étant **caractérisé en ce qu'**il comporte en outre :
- une troisième couche magnétique dite « ligne de référence » (7) en contact avec les couches de référence (2) des points mémoires, la ligne de référence (7) présentant une première extrémité (15) et une deuxième extrémité (16) ;
- des moyens d'injection (8, 9) aptes à injecter un courant d'électrons polarisé en spin à chaque extrémité (15, 16) de la ligne de référence (7) de façon à retourner l'aimantation de la ligne de référence (7) par propagation d'une paroi magnétique à travers la ligne de référence (7), ladite paroi magnétique se propageant depuis une zone proche d'une des extrémités (15, 16) de la ligne de référence (7) jusqu'à une zone proche de l'autre extrémité (16, 15) de la ligne de référence (7).

2. Dispositif selon la revendication précédente, dans lequel les moyens d'injection comportent :
- une alimentation apte à générer un courant d'électrons ;
- des premiers moyens de circulation d'un courant d'électrons polarisé en spin (8) disposés au contact de la première extrémité (15) de la ligne de référence (7), les premiers moyens de circulation d'un courant d'électrons polarisés en spin (8) étant aptes à polariser en spin, dans une première direction, le courant d'électrons issu de l'alimentation ;
- des deuxièmes moyens de circulation d'un courant d'électrons polarisé en spin (9) disposés au contact de la deuxième extrémité (16) de la ligne de référence (7), les deuxièmes moyens de circulation d'un courant d'électrons polarisés en spin (9) étant aptes à polariser en spin, dans une deuxième direction, le courant d'électrons issu de l'alimentation, la deuxième direction étant opposée à la première direction.

3. Dispositif magnétique selon la revendication précédente, **caractérisé en ce que** les premiers moyens de circulation d'un courant d'électrons polarisés en spin (8) comportent une première couche de polarisation (80) présentant une direction d'aimantation fixe.

4. Dispositif selon la revendication précédente, **caractérisé en ce que** les premiers moyens de circulation d'un courant d'électrons polarisés en spin (8) comportent une première couche antiferromagnétique (81) en contact avec la première couche de polarisation (80).

5. Dispositif selon l'une quelconque des revendications 3 à 4, **caractérisé en ce que** les premiers moyens de circulation d'un courant d'électrons polarisé en spin (8) comportent une première couche non-magnétique (82) disposée entre la première couche de polarisation et la première extrémité (15) de la ligne de référence (7).

6. Dispositif selon l'une quelconque des revendications 4 ou 5, **caractérisé en ce que** les premiers moyens de circulation d'un courant d'électrons polarisé en spin (8) comportent une deuxième couche de métal électriquement conducteur (84) disposée entre l'alimentation et la première couche antiferromagnétique (81).

7. Dispositif selon l'une quelconque des revendications 3 à 6, **caractérisé en ce que** les deuxièmes moyens de circulation d'un courant d'électrons polarisé en spin (9) comportent une deuxième couche de polarisation (90) présentant une direction d'aimantation fixe, la direction d'aimantation de la deuxième couche de polarisation (90) étant opposée à la direction d'aimantation de la première couche de polarisation (80).

8. Dispositif selon la revendication précédente, **caractérisé en ce que** les deuxièmes moyens de circulation d'un courant d'électrons polarisé en spin (9) comportent une troisième couche antiferromagnétique (91) en contact avec la deuxième couche de polarisation (90), la troisième couche antiferromagnétique (91) étant apte à piéger la direction d'aimantation de la deuxième couche de polarisation (90).

9. Dispositif selon la revendication 7, **caractérisé en ce que** les deuxièmes moyens de circulation d'un courant d'électrons polarisé en spin (9) comportent :
- une troisième couche antiferromagnétique (91) en contact avec une couche ferromagnétique d'orientation (93) ;
- une couche ferromagnétique d'orientation (93) présentant une direction d'aimantation fixe, la direction d'aimantation de la couche ferromagnétique d'orientation (93) étant opposée à la direction d'aimantation de la deuxième couche de polarisation (90) ;
- une première couche de couplage antiferromagnétique (94) insérée entre la deuxième couche ferromagnétique de polarisation (90) et la couche ferromagnétique d'orientation (93).

10. Dispositif selon l'une quelconque des revendications 7 à 9, **caractérisé en ce que** les deuxièmes moyens de circulation d'un courant d'électrons polarisé en spin (9) comportent une troisième couche non-magnétique (92) disposée entre la deuxième couche de polarisation (90) et la deuxième extrémité (16) de la ligne de référence (7).

11. Dispositif selon l'une quelconque des revendications 7 à 10, **caractérisé en ce que** les deuxièmes moyens de circulation d'un courant d'électrons polarisé en spin (9) comportent une quatrième couche de métal électriquement conducteur (95).

12. Procédé d'écriture d'une information dans la couche de stockage d'un des points mémoires d'un dispositif magnétique selon l'une quelconque des revendications 1 à 11, **caractérisé en ce qu'**il comporte les étapes suivantes:
- une étape d'envoi à travers la ligne de référence (7) d'un courant d'électrons polarisé en spin (I) de façon à contrôler la direction d'aimantation de la ligne de référence (7) ;
- une étape d'envoi à travers du point mémoire (1) d'un courant d'électrons transversal (I') de façon à modifier, par transfert de spin, la direction d'aimantation de la couche de stockage (3) en fonction de la direction d'aimantation de la couche de référence (2).

13. Procédé d'écriture selon la revendication précédente, **caractérisé en ce que** le courant d'électrons transversal (I') présente une polarité constante quelque soit l'information à écrire dans la couche de stockage (3).

14. Procédé d'écriture d'une information dans la couche de stockage d'un des points mémoires d'un dispositif magnétique selon l'une quelconque des revendications 1 à 11, **caractérisé en ce qu'**il comporte l'étape suivante :
- une étape d'envoi à travers la ligne de référence (7) d'un courant d'électrons polarisé en spin (I) de polarité constante quelle que soit l'information à écrire dans la couche de stockage (3).de façon à orienter la direction d'aimantation de la ligne de référence (7) toujours dans la même direction à chaque événement d'écriture ;
- une étape d'envoi à travers le point mémoire (1) d'un courant d'électrons transversal (I'), la polarité du courant d'électrons transversal (I') étant choisie de façon à ce que la direction d'aimantation de la couche de stockage (3) s'aligne soit parallèlement soit antiparallèlement à la direction d'aimantation de la couche de référence (2).

15. Procédé de lecture d'une information stockée dans la couche de stockage d'un des points mémoires d'un dispositif selon l'une quelconque des revendications 1 à 11, **caractérisé en ce qu'**il comporte les étapes suivantes:
- une étape d'envoi d'un premier courant d'électrons polarisé en spin (I) à travers la ligne de référence (7), le premier courant d'électrons polarisé en spin (I) présentant une première polarité choisie de façon à orienter l'aimantation de la ligne de référence (7) dans une première direction ;
- une étape d'envoi d'un courant d'électrons transversal (I") à travers le point mémoire (1) de façon à lire la résistance du point mémoire (1);
- une étape d'envoi d'un deuxième courant d'électrons polarisé en spin à travers la ligne de référence, le deuxième courant d'électrons polarisé en spin (I) présentant une deuxième polarité choisie de façon à orienter l'aimantation de la ligne de référence (7) dans une deuxième direction ;
- une étape d'envoi d'un courant d'électrons transversal (I") à travers le point mémoire (1) de façon à lire la résistance du point mémoire (1);
- une étape de comparaison entre la résistance du point mémoire (1) après l'envoi du premier courant d'électrons polarisé en spin et la résistance du point mémoire (1) après l'envoi du deuxième courant d'électrons polarisé en spin.

## Patentansprüche

1. Magnetische Vorrichtung, umfassend:
- wenigstens zwei Speicherpunkte (1), wobei jeder Speicherpunkt umfasst:
∘ eine erste Magnetschicht, bezeichnet als "Referenzschicht" (2), wobei die Referenzschicht (2) eine variable Magnetisierungsrichtung aufweist;
∘ eine zweite Magnetschicht, bezeichnet als "Speicherschicht" (3), wobei die Speicherschicht (3) eine variable Magnetisierungsrichtung aufweist;
∘ einen Abstandshalter (4), der die Referenzschicht (2) und die Speicherschicht (3) trennt, wobei die Referenzschicht (2) und die Speicherschicht (3) durch den Abstandshalter (4) magnetisch entkoppelt sind;
∘ Mittel, die geeignet sind, einen transversalen Elektronenstrom durch den Speicherpunkt (1) hindurchtreten zu lassen;
wobei die magnetische Vorrichtung **dadurch gekennzeichnet ist, dass** sie darüber hinaus umfasst:
- eine dritte Magnetschicht, bezeichnet als "Referenzlinie" (7), die mit den Referenzschichten (2) der Speicherpunkte in Kontakt ist, wobei die Referenzlinie (7) ein erstes Ende (15) und ein zweites Ende (16) aufweist;
- Einschießmittel (8, 9), die geeignet sind, einen Elektronenstrom einzuschießen, der an jedem Ende (15, 16) der Referenzlinie (7) derart spinförmig polarisiert ist, dass die Magnetisierung der Referenzlinie (7) per Verbreitung einer magnetischen Wand durch die Referenzlinie (7) umgekehrt wird, wobei die genannte magnetische Wand sich von einem Bereich in der Nähe eines der Enden (15, 16) der Referenzlinie (7) bis zu einem Bereich in der Nähe des anderen Endes (16, 15) der Referenzlinie (7) verbreitet.

2. Vorrichtung gemäß dem voranstehenden Anspruch, bei der die Einschießmittel umfassen:
- eine Versorgung, die geeignet ist, einen Elektronenstrom zu generieren;
- erste Umlaufmittel eines spinförmig polarisierten Elektronenstroms (8), die in Kontakt des ersten Endes (15) der Referenzlinie (7) angeordnet sind, wobei die ersten Umlaufmittel eines spinförmig polarisierten Elektronenstroms (8) geeignet sind, den aus der Versorgung stammenden Elektronenstrom spinförmig in einer ersten Richtung zu polarisieren;
- zweite Umlaufmittel eines spinförmig polarisierten Elektronenstroms (9), die in Kontakt mit dem zweiten Ende (16) der Referenzlinie (7) angeordnet sind, wobei die zweiten Umlaufmittel eines spinförmig polarisierten Elektronenstroms (9) geeignet sind, den aus der Versorgung stammenden Elektronenstrom in einer spinförmig zweiten Richtung zu polarisieren, wobei die zweite Richtung zur ersten Richtung entgegengesetzt ist.

3. Magnetische Vorrichtung gemäß dem voranstehenden Anspruch, **dadurch gekennzeichnet, dass** die ersten Umlaufmittel eines spinförmig polarisierten Elektronenstroms (8) eine erste Polarisationsschicht (80) aufweisen, der eine feste Magnetisierungsrichtung aufweist.

4. Vorrichtung gemäß dem voranstehenden Anspruch, **dadurch gekennzeichnet, dass** die ersten Umlaufmittel eines spinförmigen polarisierten Elektronenstroms (8) eine erste antiferromagnetische Schicht (81) in Kontakt mit der ersten Polarisationsschicht (80) umfassen.

5. Vorrichtung gemäß irgendeinem der Ansprüche 3 bis 4, **dadurch gekennzeichnet, dass** die ersten Umlaufmittel eines spinförmig polarisierten Elektronenstroms (8) eine erste, nicht magnetische Schicht (82) umfassen, die zwischen der ersten Polarisationsschicht und dem ersten Ende (15) der Referenzlinie (7) angeordnet ist.

6. Vorrichtung gemäß irgendeinem der Ansprüche 4 oder 5, **dadurch gekennzeichnet, dass** die ersten Umlaufmittel eines spinförmig polarisierten Elektronenstroms (8) eine zweite, elektrisch leitende Metallschicht (84) umfassen, die zwischen der Versorgung und der ersten antiferromagnetischen Schicht (81) angeordnet ist.

7. Vorrichtung gemäß irgendeinem der Ansprüche 3 bis 6, **dadurch gekennzeichnet, dass** die zweiten Umlaufmittel eines spinförmig polarisierten Elektronenstroms (9) eine zweite Polarisierungsschicht (90) umfassen, die eine feste Magnetisierungsrichtung aufweisen, wobei die Magnetisierungsschicht der zweiten Polarisierungsschicht (90) der Magnetisierungsrichtung der ersten Polarisierungsschicht (80) gegenüberliegt.

8. Vorrichtung gemäß dem voranstehenden Anspruch, **dadurch gekennzeichnet, dass** die zweiten Umlaufmittel eines spinförmigen polarisierten Elektronenstroms (9) eine dritte antiferromagnetische Schicht (919) in Kontakt mit der zweiten Polarisierungsschicht (90) umfassen, wobei die dritte antiferromagnetische (91) Schicht geeignet ist, die Magnetisierungsrichtung der zweiten Polarisierungsschicht (90) eizuschließen.

9. Vorrichtung gemäß Anspruch 7, **dadurch gekennzeichnet, dass** die zweiten Umlaufmittel eines spinförmig polarisierten Elektronenstroms (9) umfassen:
- eine dritte antiferromagnetische Schicht (91) in Kontakt mit einer ferromagnetischen Ausrichtungsschicht (93);
- eine ferromagnetische Ausrichtungsschicht (93), die eine feste Magnetisierungsschicht aufweist, wobei die Magnetisierungsrichtung der ferromagnetischen Ausrichtungsschicht (93) der Magnetisierungsrichtung der zweiten Polarisierungsschicht (90) entgegengesetzt ist;
- eine erste antiferromagnetische Kopplungsschicht (94), die zwischen der zweiten ferromagnetischen Polarisierungsschicht (90) und der ferromagnetischen Ausrichtungsschicht (93) eingefügt ist.

10. Vorrichtung gemäß irgendeinem der Ansprüche 7 bis 9, **dadurch gekennzeichnet, dass** die zweiten Umlaufmittel eines spinförmig polarisierten Elektronenstroms (9) eine dritte nicht magnetische Schicht (92) umfassen, die zwischen der zweiten Polarisierungsschicht (90) und dem zweiten Ende (16) der Referenzlinie (7) angeordnet ist.

11. Vorrichtung gemäß irgendeinem der Ansprüche 7 bis 10, **dadurch gekennzeichnet, dass** die zweiten Umlaufmittel eines spinförmig polarisierten Elektronenstroms (9) eine vierte, elektrisch leitende Metallschicht (95) umfassen.

12. Schreibverfahren einer Information in der Speicherschicht eines der Speicherpunkte einer magnetischen Vorrichtung gemäß irgendeinem der Ansprüche 1 bis 11, **dadurch gekennzeichnet, dass** es die folgenden Schritte umfasst:
- einen Versandschritt durch die Referenzlinie (7) eines spinförmig polarisierten Elektronenstroms (I), derart, dass die Magnetisierungsrichtung der Referenzlinie (7) kontrolliert wird;
- einen Versandschritt durch den Speicherpunkt (1) eines transversalen Elektronenstroms (I') derart, dass durch den Spintransfer die Magnetisierungsrichtung der Speicherschicht (3) in Abhängigkeit von der Magnetisierungsrichtung der Referenzschicht (2) abgeändert wird.

13. Schreibverfahren gemäß dem voranstehenden Anspruch, **dadurch gekennzeichnet, dass** der transversale Elektronenstrom (I') unabhängig von der in die Speicherschicht (3) zu schreibenden Information eine konstante Polarität aufweist.

14. Schreibverfahren einer Information in der Speicherschicht eines der Speicherpunkte einer magnetischen Vorrichtung gemäß irgendeinem der Ansprüche 1 bis 11, **dadurch gekennzeichnet, dass** es den folgenden Schritt umfasst:
- einen Versandschritt durch die Referenzlinie (7) eines spinförmig polarisierten Elektronenstroms (I) mit konstanter Polarität unabhängig von der in die Speicherschicht (3) zu schreibenden Information derart, dass die Magnetisierungsrichtung der Referenzlinie (7) bei jedem Schreibereignis stets in derselben Richtung ausgerichtet ist;
- einen Versandschritt durch den Speicherpunkt (1) eines transversalen Elektronenstroms (I'), wobei die Polarität des transversalen Elektronenstroms (I') derart ausgewählt ist, dass die Magnetisierungsrichtung der Speicherschicht (3) entweder parallel oder antiparallel zur Magnetisierungsrichtung der Referenzschicht (2) gefluchtet ist.

15. Leseverfahren einer Information, die in der Speicherschicht einer der Speicherpunkte einer Vorrichtung gemäß irgendeinem der Ansprüche 1 bis 11 gespeichert ist, **dadurch gekennzeichnet, dass** es die folgenden Schritte umfasst:
- einen Versandschritt eines ersten spinförmig polarisierten Elektronenstroms (I) durch die Referenzlinie (7), wobei der erste spinförmig polarisierte Elektronenstrom (I) eine erste Polarität aufweist, die derart ausgewählt ist, dass die Versorgung der Referenzlinie (7) in einer ersten Richtung ausgerichtet ist;
- einen Versandschritt eines transversalen Elektronenstroms (I") durch den Speicherpunkt (1) derart, dass der Widerstand des Speicherpunktes (1) gelesen wird;
- einen Versandschritt eines zweiten, spinförmig polarisierten Elektronenstroms durch die Referenzlinie, wobei der zweite spinförmig polarisierte Elektronenstrom (I) eine zweite Polarität aufweist, die derart ausgewählt ist, dass die Magnetisierung der Referenzlinie (7) in einer zweiten Richtung ausgerichtet ist;
- einen Versandschritt eines transversalen Elektronenstroms (I") durch den Speicherpunkt (1) derart, dass der Widerstand des Speicherpunktes (1) gelesen wird;
- einen Vergleichsschritt zwischen dem Widerstand des Speicherpunktes (1) nach dem Versand des ersten spinförmig polarisierten Elektronenstroms und dem Widerstand des Speicherpunktes (1) nach dem Versand des zweiten spinförmig polarisierten Elektronenstroms.

## Claims

1. Magnetic device comprising:
- at least two memory cells (1), each memory cell comprising:
∘ a first magnetic layer called the "reference layer" (2), the reference layer (2) having a variable direction of magnetisation;
∘ a second magnetic layer called the "storage layer" (3), the storage layer (3) having a variable direction of magnetisation;
∘ a spacer (4) that separates the reference layer (2) and the storage layer (3), the reference layer (2) and the storage layer (3) being magnetically decoupled through the spacer (4);
∘ means of passing a transverse current of electrons through the memory cell;
the magnetic device being **characterised in that** it also comprises:
- a third magnetic layer called the "reference line" (7) in contact with the reference layers (2) of the memory cells (1), the reference line (7) having a first end (15) and a second end (16);
- injection means (8, 9) capable of injecting a current of spin-polarised electrons at each end (15, 16) of the "reference line" (7) so as to return the magnetisation of the reference line (7) by propagation of a magnetic wall through the reference line (7), said magnetic wall propagating from a zone close to one of the ends (15, 16) of the reference line (7) as far as a zone close to the other end (16, 15) of the reference line (7).

2. Device according to the previous claim, in which the injection means comprise:
- a power supply capable of generate a current of electrons;
- first means of circulating a current of spin-polarised electrons (8) in contact with the first end (15) of the reference line (7), the first means of circulating a current of spin-polarised electrons (8) being capable of spin-polarising the current of electrons output from the power supply in a first direction;
- second means of circulating a current of spin-polarised electrons (9) at the contact of the second end (16) of the reference line (7), the second means of circulating a current of spin-polarised electrons (9) being capable of spin-polarising the current of electrons output from the power supply in a second direction, the second direction being opposite to the first direction;

3. Magnetic device according to the previous claim, **characterised in that** the first means of circulating a current of spin-polarised electrons (8) comprise a first polarisation layer (80) with a fixed direction of magnetisation.

4. Device according to the previous claim, **characterised in that** the first means of circulating a current of spin-polarised electrons (8) comprise a first anti-ferromagnetic layer (81) in contact with the first polarisation layer (80).

5. Device according to either claim 3 or 4, **characterised in that** the first means of circulating a current of spin-polarised electrons (8) comprise a first non-magnetic layer (82) located between the first polarisation layer and the first end (15) of the reference line (7).

6. Device according to either claim 4 or 5, **characterised in that** the first means of circulating a current of spin-polarised electrons (8) comprise a second layer of electrically conducting material (84) between the power supply and the first anti-ferromagnetic layer (81).

7. Device according to any one of claims 3 to 6, **characterised in that** the second means of circulating a current of spin-polarised electrons (9) comprise a second polarisation layer (90) with a fixed direction of magnetisation, the direction of magnetisation of the second polarisation layer (90) being opposite to the direction of magnetisation of the first polarisation layer (80).

8. Device according to the previous claim, **characterised in that** the second means of circulating a current of spin-polarised electrons (9) comprise a third anti-ferromagnetic layer (91) in contact with the second polarisation layer (90), the third anti-ferromagnetic layer (91) being capable of pinning the direction of magnetisation of the second polarisation layer (90).

9. Device according to claim 7, **characterised in that** the second means of circulating a current of spin-polarised electrons (9) comprise:
- a third anti-ferromagnetic layer (91) in contact with a ferromagnetic orientation layer (93);
- an orientation ferromagnetic layer (93) with a fixed direction of magnetisation, the direction of magnetisation of the ferromagnetic orientation layer (93) being opposite to the direction of magnetisation of the second polarisation layer (90);
- a first anti-ferromagnetic coupling layer (94) inserted between the second ferromagnetic polarisation layer (90) and the ferromagnetic orientation layer (93);

10. Device according to any one of claims 7 to 9, **characterised in that** the second means of circulating a current of spin-polarised electrons (9) comprise a third non-magnetic layer (92) located between the second polarisation layer (90) and the second end (16) of the reference line (7).

11. Device according to any one of claims 7 to 10, **characterised in that** the second means of circulating a current of spin-polarised electrons (9) comprise a fourth layer (95) of electrically conducting material.

12. Method of writing information into the memory cells storage layer of a magnetic device according to any one of claims 1 to 11, **characterised in that** it comprises the following steps.
- a step to send a current of spin-polarised electrons (I) through the reference line (7) so as to control the direction of magnetisation of the reference layer (2);
- a step to send a transverse current of electrons (I') through the memory cell (1) so as to modify the direction of magnetisation of the storage layer (2) by spin transfer, as a function of the direction of magnetisation of the reference layer (2).

13. Method of writing according to the previous claim, **characterised in that** the transverse current of electrons (I') has a constant polarity regardless of the information to be written in the storage layer (3).

14. Method of writing information into the memory cells storage layer of a magnetic device according to any one of claims 1 to 11, **characterised in that** it includes the following steps:
- a step to send a current of spin-polarised electrons (I) with constant polarity regardless of the information to be written in the storage layer (3) through the reference line (7) such that the direction of magnetisation of the reference line (7) is always oriented in the same direction during each write event;
- a step to send a transverse current of electrons (I') through the memory cell (1), the polarity of the transverse current of electrons (I') being chosen such that the direction of magnetisation of the storage layer (3) is aligned to be either parallel to or anti-parallel to the direction of magnetisation of the reference layer (2).

15. Method of reading information stored in the memory cells storage layer of a device according to any one of claims 1 to 11, **characterised in that** it includes the following steps:
- a step to send a first current of spin-polarised electrons (I) through the reference line (7), the first current of spin-polarised electrons (I) having a first polarity chosen such that the magnetisation of the reference line (7) is oriented in a first direction;
- a step to send a transverse current of electrons (I') through the memory cell (1) so as to read the resistance of the memory cell (1);
- a step to send a second current of spin-polarised electrons through the reference line, the second current of spin-polarised electrons (I) having a second polarity chosen such that the magnetisation of the reference line (7) is oriented in a second direction;
- a step to send a transverse current of electrons (I") through the memory cell (1) so as to read the resistance of the memory cell (1);
- a step to compare the resistance of the memory cell (1) after sending first current of spin-polarised electrons and the desistance of the memory cell (1) after sending the second current of spin-polarised electrons.
